# EUROPÄISCHE PATENTSCHRIFT

(11) **EP 2 575 418 B1**
(45) Veröffentlichungstag und Bekanntmachung des Hinweises auf die Patenterteilung: **12.07.2017**
(21) Anmeldenummer: 12199775.3
(22) Anmeldetag: 18.05.2011
(51) Int. Cl.: H05K 7/20, F28F 3/12, H01L 23/473, H01L 23/00

(54) **Elektronikkühler und Verfahren zum Herstellen eines Elektronikkühlers**
Electronics cooler and method for manufacturing the same
Refroidisseur électronique et procédé destiné à la fabrication d'un refroidisseur électronique

(30) Priorität: 20.05.2010 DE 102010029178
(43) Veröffentlichungstag der Anmeldung: 03.04.2013
(62) Teilanmeldung aus: 11166600.4
(73) Patentinhaber: MAHLE Behr GmbH & Co. KG, 70469 Stuttgart (DE)
(72) Erfinder: Heckenberger, Thomas, Dr.-Ing., 5837 Fentange (LU); Himmer, Thomas, Dipl.-Ing. (FH), 73326 Reichenbach (DE); Moldovan, Florin, Dipl-Ing., 70569 Stuttgart (DE); Moser, Michael, Dipl.-Ing., 73479 Ellwangen (DE); Riedel, Rudolf, Dr.-Ing., 75173 Pforzheim (DE); Schiehlen, Thomas, Dipl.-Ing., 89174 Altheim (DE); Steinbach, Martin, Dipl-Ing. (FH), 71336 Waiblingen (DE)
(74) Vertreter: Grauel, Andreas

(56) Entgegenhaltungen:
- WO-A2-02/49104
- DE-A1- 10 315 225
- DE-A1-102007 046 349
- DE-A1-102008 027 293
- FR-A1- 2 607 911

## Beschreibung

Die vorliegende Erfindung bezieht sich auf einen Elektronikkühler, ein Verfahren zum Herstellen eines Elektronikkühlers sowie auf eine Verwendung eines Sinterverfahrens zum Aufsintern eines Elektronikbauteils auf einen Kühlkörper.

Durch die zunehmende Elektrifizierung von Kraftfahrzeugen halten immer mehr elektrische Bauteile und Steuergeräte Einzug in die Fahrzeugarchitektur.

Speziell im Fall von Elektro- oder Hybridfahrzeugen steigt der Elektronikanteil erheblich. Bei Elektrofahrzeugen müssen starke Ströme und Spannungen geregelt und gesteuert werden, hierzu sind Leistungselektronikbauteile notwendig. Durch die Schaltung der Ströme und Spannungen entstehen große Verlustleistungen, die Wärme hervorrufen. Die entstehenden Temperaturen begrenzen den Nutzbereich der Leistungselektronik. Um dieser Begrenzung entgegen zu wirken müssen die Wärmeverluste abgeführt werden. Dies kann durch die gängigen Kühlvarianten, wie Luftkühlung oder Flüssigkeitskühlung geschehen. Bevorzugt wurde über die Jahre die Luftkühlung, da eine Flüssigkeitskühlung über lange Zeit für den Einsatz in der Elektronikumgebung, wie Schaltschränken, nicht denkbar war. Um jedoch eine bessere Ausnutzung und höhere Belastung der Bauteile zu ermöglichen ist eine Umstellung des Kühlungsprinzips von Luftkühlung auf die effektivere Flüssigkeitskühlung notwendig.

Derzeitige Kühler für Elektronik besitzen hinsichtlich der Kühleigenschaften eine hinreichende Kühlung, jedoch wird einer homogenen Temperaturverteilung kaum Rechnung getragen. Dies hat zur Folge, dass ein Ausnutzen der Temperaturbelastbarkeit für die Halbleitermaterialien nicht gegeben ist.

Zudem werden Kühler gefertigt, die deutlich größere Abmessungen besitzen, als die Geometrie der zu kühlenden Halbleiterelemente. Damit geht auch ein deutlich höheres Gewicht einher und dadurch höhere Kosten für den höheren Materialanteil.

Gegenwärtige Kühler werden gesintert und nach dem Sintern mittels Dichtungen und Schraubverbindungen zusammengebaut, hierdurch entsteht ein zusätzlicher Montageaufwand. Zudem ist eine mechanische Bearbeitung der Dichtflächen notwendig. Durch mehrere Fertigungsschritte geht ein weiteres Fertigungsrisiko, z.B. aufgrund Dichtprüfen von Elektronikbauteilen, Zusammenbau etc., einher. Die DE 10 2007 046 349 A1 beschreibt einen Elektronikkühler nach dem Oberbegriff von Anspruch 1. Es ist die Aufgabe der vorliegenden Erfindung einen verbesserten Elektronikkühler und ein verbessertes Verfahren zum Herstellen eines Elektronikkühlers zu schaffen.

Diese Aufgabe wird durch einen Elektronikkühler gemäß Anspruch 1, ein Verfahren zum Herstellen eines Elektronikkühlers gemäß Anspruch 6 sowie durch eine Verwendung eines Sinterverfahrens gemäß Anspruch 7 gelöst.

Der vorliegenden Erfindung liegt die Erkenntnis zugrunde, dass Elektronikbauteile, beispielswiese Elektronikhalbleiterbauteile, direkt auf einen Kühler aufgesintert werden können. Auf diese Weise kann ein Kühler zur Temperierung von Hochleistungselektronikkomponenten realisiert werden, auf dessen Oberfläche die Leistungselektronikkomponenten direkt aufgebracht werden.

Vorteilhafterweise wird dadurch eine ordnungsgemäße Kühlung der Elektronikhalbleiterbauteile ermöglicht. Die Kühlung ist effizient und geht homogen von statten.

Um ein Sintern direkt auf der Kühleroberfläche zu ermöglichen sind einige Vorkehrungen zu treffen. Der Sinterprozeß erzeugt hohe Temperaturen und hohe Drücke, die den Kühler bleibend verformen können. Bei Aufsintern der Elektronikbauteile können ein Druck von mehr als 8 MPa und eine Temperatur zwischen 350 - 600 K auftreten.

Als Vorkehrung kann beispielsweise eine Kanalgeometrie ungefähr im Breiten-Höhenverhältnis von 1 : 1,2 - 2,0mm ausgeführt werden. Zudem können Aluminiumlegierungen verwendet werden, die nach dem Löten im Auslagerungsprozeß, die Härte für den Sinterprozeß erhalten.

Die vorliegende Erfindung schafft einen Elektronikkühler nach Anspruch 1, mit folgendem Merkmal: einem Kühlkörper, der eine Mehrzahl von Fluidkanälen und eine Wärmeübertragungsfläche zum Aufsintern mindestens eines Elektronikbauteils aufweist.

Der Kühlkörper kann mehrstückig aufgebaut sein und einen Anschluss zur Zuführung eines Fluids und einen Anschluss zum Abführen des Fluids aufweisen, das durch die Mehrzahl von Fluidkanälen geleitet werden kann. Bei dem Fluid kann es sich um ein Kühlmittel handeln. Abgesehen von den Anschlüssen kann der Kühlkörper fluiddicht ausgeführt sein. Die Wärmeübertragungsfläche kann eine oder mehrere außenliegende Oberflächen des Kühlkörpers bedecken. Die Wärmeübertragungsfläche kann einen von der Mehrzahl von Fluidkanälen durchzogenen Bereich des Kühlkörpers abdecken, so dass eine von der Wärmeübertragungsfläche aufgenommene Wärme schnell über die Fluidkanäle abgeführt werden kann. Die Wärmeübertragungsfläche ist bereits vor dem Aufsintern des mindestens einen Elektronikbauteils fester Bestandteil des Kühlkörpers, also starr mit dem übrigen Teil des Kühlkörpers verbunden. Somit kann das Aufsintern auf einen bereits dichtigkeitsgeprüften Kühlkörper erfolgen. Durch das Aufsintern wird das mindestens eine Elektronikbauteil direkt mit der Wärmeübertragungsfläche verbunden. Bei dem Elektronikbauteil kann es sich um ein Halbleiterbauteil handeln. Das Elektronikbauteil kann ein Teil einer Leistungselektronik darstellen.

Der Elektronikkühler kann das mindestens eine Elektronikbauteil aufweisen, das auf der Wärmeübertragungsfläche aufgesintert ist. Somit kann eine gesinterte Verbindung zwischen dem mindestens einem Elektronikbauteil und der Wärmeübertragungsfläche bestehen. Die gesinterte Verbindung ermöglicht eine zuverlässige Befestigung, die auch den hohen Anforderungen im automobilen Umfeld gerecht wird. Zusätzlich kann Abwärme des mindestens einen Elektronikbauteils über die gesinterte Verbindung ohne großen Wärmewiderstand auf die Wärmeübertragungsfläche abgeleitet werden.

Der Kühlkörper kann ein Material und eine geometrische Struktur aufweisen, die auf einen beim Aufsintern auf die Wärmeübertragungsfläche wirkenden Druck und auf eine beim Aufsintern auf die Wärmeübertragungsfläche wirkende Temperatur ausgelegt sind. Das Material kann eine Härte aufweisen, die das Aufsintern des mindestens einen Elektronikbauteils ermöglicht, ohne dass der Kühlkörper verformt wird. Beispielsweise können Aluminiumlegierungen eingesetzt werden. Die geometrische Struktur kann so gewählt sein, dass ein durch das Aufsintern auf die Wärmeübertragungsfläche einwirkender Druck gleichmäßig über den Kühlkörper verteilt wird.

Beispielsweise kann eine Höhe der Mehrzahl von Fluidkanälen dem einfachen bis zweifachen einer Breite der der Mehrzahl von Fluidkanälen entsprechen, wobei sich die Höhe im Wesentlichen orthogonal und die Breite im Wesentlichen parallel zu einer Haupterstreckungsebene der Wärmeübertragungsfläche erstreckt. Die durch das Aufsintern hervorgerufene Druckbelastung kann von Stegen zwischen den Fluidkanälen aufgenommen werden.

Gemäß nicht unter der Erfindung fallenden Ausführungsform kann der Kühlkörper als ein Extrusionsprofil ausgeformt sein. Die Wärmeübertragungsfläche kann eine Oberfläche des Extrusionsprofils sein. Auf diese Weise kann der Kühlkörper einstückig ausgeformt sein.

Gemäß einer erfindungsgemäßen Ausführungsform kann der Kühlkörper einen Schichtaufbau aus mindestens einem Kanalblech zum Ausformen der Mehrzahl von Fluidkanälen und einen Deckel aufweisen. Die Wärmeübertragungsfläche kann eine Oberfläche des Deckels sein. Mittels des Schichtaufbaus kann eine Form, Größe und eine Fluidführung des Kühlkörpers an unterschiedliche Einsatzgebiete angepasst werden.

So kann der Kühlkörper ein erstes Kanalblech und ein zweites Kanalblech aufweisen, wobei durch das erste Kanalblech ausgeformte Fluidkanäle und durch das zweite Kanalblech ausgeformte Fluidkanäle versetzt zueinander angeordnet sein können. Zwischen dem ersten und dem zweiten Kanalblech kann ein Zwischenblech angeordnet sein. Die Fluidkanäle können bezüglich ihrer Längserstreckungsrichtung parallel ausgerichtet sein. Aufgrund der versetzten Anordnung können die Fluidkanäle des ersten Kanalblechs gegenüberliegend zu Stegen angeordnet sein, die sich zwischen den Fluidkanälen des zweiten Kanalblechs befinden. Erfindungsgemäß weist der Kühlkörper ein erstes Kanalblech und ein zweites Kanalblech auf, wobei durch das erste Kanalblech ausgeformte Fluidkanäle entlang ihrer Längsrichtung jeweils mit durch das zweite Kanalblech ausgeformten Fluidkanäle verbunden sind und wobei die durch das erste Kanalblech ausgeformten Fluidkanäle sich in ihrer Breite von den durch das zweite Kanalblech ausgeformten Fluidkanälen unterscheiden. Auf diese Weise besteht an den Verbindungsstellen der Fluidkanäle des ersten und zweiten Kanalblechs ein Absatz, der sich beim Verbinden des ersten und zweiten Kanalblechs als vorteilhaft erweist.

Die vorliegende Erfindung schafft ferner ein Verfahren zum Herstellen eines Elektronikkühlers, das den folgenden Schritt umfasst: Aufsintern mindestens eines Elektronikbauteils auf eine Wärmeübertragungsfläche eines Kühlkörpers, der eine Mehrzahl von Fluidkanälen und die Wärmeübertragungsfläche zum Aufsintern des mindestens einen Elektronikbauteils aufweist.

Erfindungsgemäß wird eine Verwendung eines Sinterverfahrens vorgeschlagen, um mindestens ein Elektronikbauteil auf eine Wärmeübertragungsfläche eines Kühlkörpers aufzusintern, der eine Mehrzahl von Fluidkanälen und die Wärmeübertragungsfläche zum Aufsintern des mindestens einen Elektronikbauteils aufweist.

Zum Aufsintern kann beispielsweise eine Silber-Sinter-Technologie eingesetzt werden.

Vorteilhafterweise kann dadurch auf das Herstellen einer sinterfähigen Kühlstruktur verzichtet werden, die durch Fließpressen erzeugt wird. Auch kann ein Schritt des Vorbereitens und Handlings entfallen, um die Sintermaschine mit der Kühlstruktur zu bestücken. Ein wesentlicher Vorteil besteht darin, dass nach dem Sintern das aufwendige Assemblieren der Teile und das anschließende Prüfen des Kühlers auf Dichtigkeit nicht erforderlich ist.

Durch die erfindungsgemäße Vorgehensweise werden die Handlingskosten minimiert, da direkt auf einen dichtgeprüften Kühler gesintert wird. Somit lässt sich die Herstellungszeit sowie damit die Herstellungskosten deutlich senken. Natürlich ist die abschließende Dichtprüfung immer noch notwendig.

Gesinterte Halbleiterbauteile und Halbleiterbauteile, die direkt auf einen speziell dafür konstruierten Kühler gesintert sind, können sowohl im Automobilbereich, als auch im Bereich der Windkraft Verwendung finden und generieren.

Durch den Einsatz eines Materiales, wie beispielsweise Aluminium werden sowohl Kosten- als auch Gewichtsersparnisse generiert. Zudem werden die Abmessungen auf ein Minimum reduziert.

Der erfindungsgemäße Ansatz stellt Anforderungen im Bereich des Lötens, wie auch im Bereich der thermischen und mechanischen Auslegung. Der Grund hierfür liegt in der Kombination von Wasserkühlung im Hochspannungsbereich. Vor allem der Einsatz in Windkraftturbinen darf durch den Ausfall eines erfindungsgemäß hergestellten Bauteiles keine Schäden im Bereich der Elektronik verursachen somit muss zwingend sichergestellt werden, dass dieses Bauteil nicht versagt.

Vorteilhafte Ausführungsbeispiele der vorliegenden Erfindung werden nachfolgend Bezug nehmend auf die beiliegenden Zeichnungen näher erläutert. Es zeigen:
Figuren 1 bis 6 Darstellungen von Elektronikkühlern, gemäß einem Ausführungsbeispiel das nicht unter der vorliegenden Erfindung fällt;
Figuren 7 bis 9 Darstellungen von Elektronikkühlern, gemäß einem Ausführungsbeispiel der vorliegenden Erfindung;
Figuren 10 eine Darstellung eines Elektronikkühlers, gemäß einem weiteren Ausführungsbeispiel;
Figuren 11 bis 16 Darstellungen von Elektronikkühlern, gemäß einem weiteren Ausführungsbeispiel;
Figuren 17 bis 63 Darstellungen von Elektronikkühlern, gemäß weiteren Ausführungsbeispielen; und
Fig. 64 ein Ablaufdiagramm eines erfindungsgemäßen Verfahrens.

In der nachfolgenden Beschreibung der nicht unter der Erfindung fallenden Ausführungsbeispiele und der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

Die in den nachfolgenden Ausführungsbeispielen beschriebenen Kühler sind so ausgelegt und konstruiert, dass sie sowohl die erforderlichen Festigkeitsanforderungen als auch die thermischen Anforderungen erfüllen.

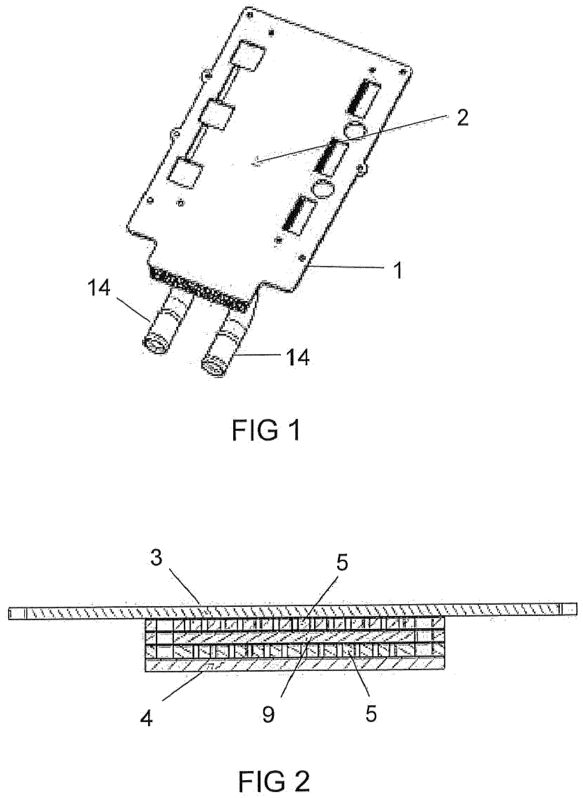

Die Figuren 1 bis 6 zeigen Darstellungen von Elektronikkühlern, gemäß einem Ausführungsbeispiel. Gezeigt ist eine I-Flow-Variante mit zwei unterschiedlichen Kanalblechen und einem Zwischenblech die eine Art Grundbaustein bilden. Die Anzahl dieser Kanäle ist von der Massenstromgröße und dem zulässigen Druckabfall abhängig. Die Längskanäle sind um eine halbe Teilung versetzt, damit der Kraftfluss der während des Sinterns entsteht, immer durch die Stege geht und so eine lokale Verformung des Deckels verhindert. Die Teile können z.B. durch Stanzen, Laserstrahl-Schneiden, Wasserstrahl-Schneiden oder Ähnliches gefertigt werden.

Fig. 1 zeigt eine I-Flow-Variante oder alternativ eine U-Flow-Variante eines Elektronikkühlers. Der Kühler weist einen Kühlkörper 1 mit einer Sinterfläche 2 auf. Die Sinterfläche 2 ist in der in Fig. 2 gezeigten Darstellung auf einer Oberseite des Kühlkörpers 1 angeordnet. An den Kühlkörper 1 sind Anschlussleitungen 14 zum Zuführen und Abführen eines Fluids angeschlossen. Das Fluid kann durch Fluidleitungen geführt werden, die unterhalb der Sinterfläche 2 durch den Kühlkörper geführt sind. Die Sinterfläche 2 dient als Wärmeübertragungsfläche. Auf die Sinterfläche 2 können ein oder mehrere Elektronikbauteile (nicht gezeigt in den Figuren) mittels eines geeigneten Sinterverfahrens aufgesintert werden.

Fig. 2 zeigt einen Querschnitt durch den in Fig. 1 gezeigten Kühler im Kanalbereich. Der Kühler weist von oben nach unten gesehen einen Schichtaufbau aus einem oberen Deckel 3, einem ersten Kanalblech 5, einer Zwischenscheibe oder einem Zwischenblech 9, einem zweiten Kanalblech 5 und einem unteren Deckel 4 auf. Die Kanalbleche 5 weisen jeweils Längsstege auf. Durch sich zwischen den Längsstegen befindliche Aussparungen werden Fluidkanäle ausgebildet. Fluidkanäle des ersten Kanalblechs 5 werden auf einer Seite durch den oberen Deckel 3 und auf einer gegenüberliegenden Seite durch die Zwischenscheibe 9 abgeschlossen. Die Längsstege im zweiten Kanalblech 5 sind gegenüber den Längsstegen im ersten Kanalblech 5 um eine halbe Teilung versetzt.

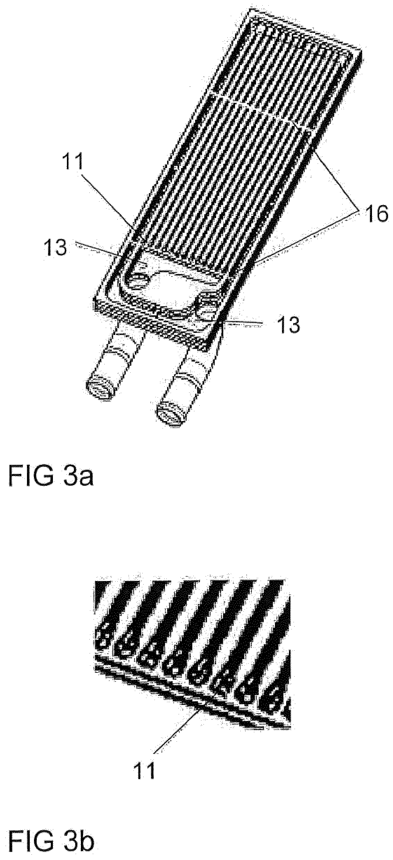

Fig. 3a zeigt eine ISO Ansicht des in Fig. 1 gezeigten Elektronikkühlers ohne Deckel von oben zum ersten Kanalblech. Der Kühler weist einen Sammelkanal ein 13 und einen Sammelkanal aus 13 auf, die die Anschlussleitungen mit den Fluidkanälen des Kühlers verbinden. Zu erkennen sind die Längsstege des ersten Kanalblechs, die über Querstege verbunden sind. Die Querstege sind für die Fertigung notwendig.

Fig. 3b zeigt einen Ausschnitt des in Fig. 3a gezeigten Kühlers. Gezeigt sind Kanäle 11 des ersten Kanalblechs. Im Sammelbereich sind die Kanäle 11 breiter, was zu einer Reduzierung des Druckabfalles führt.

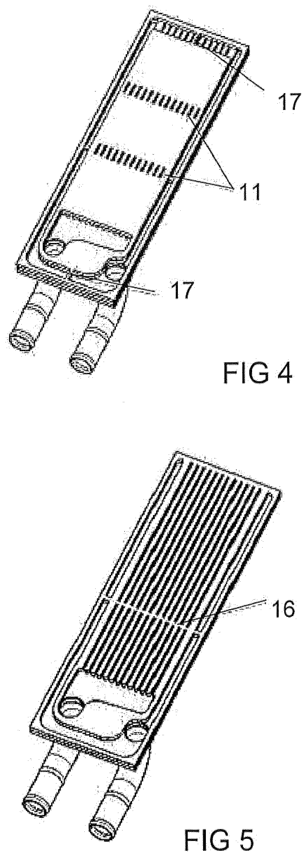

Fig. 4 zeigt eine ISO Ansicht des in Fig. 1 gezeigten Elektronikkühlers von oben zum Zwischenblech. Gezeigt sind Längsstege 17 und Aussparungen 11 im Bereich der in Fig. 3a gezeigten Querstege. Die Aussparungen 11 in dem Zwischenblech sind den Längsstegen entsprechend auch um eine halbe Teilung versetzt. Die sind für die Funktion notwendig, weil die Fluidströmung die Querstege umgehen soll. Die Längsstege 17 sind für die Fertigung der Zwischenscheibe notwendig.

Fig. 5 zeigt eine ISO Ansicht des in Fig. 1 gezeigten Elektronikkühlers von oben zum zweiten Kanalblech. Der Quersteg 16 ist wie beim ersten Kanalblech für die Fertigung notwendig und dient auch zur Festigung des Kanalbleches vor der Montage. Es verhindert das Biegen und sogar Abbrechen der Stege während der Fertigung.

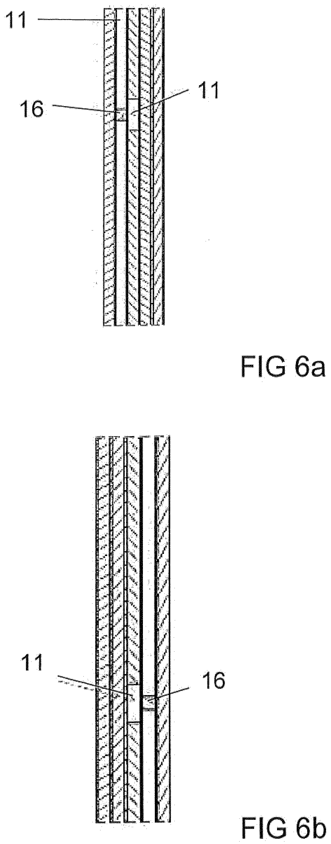

Fig. 6a zeigt einen Längsschnitt des in Fig. 1 gezeigten Elektronikkühlers durch die Kanäle im ersten Kanalblech. Gezeigt ist ein Kanal im ersten Kanalblech, der durch einen Quersteg 16 unterbrochen ist. Eine Umlenkung 11 ist in der Zwischenscheibe für den Quersteg 16 im Kanal des ersten Kanalblechs vorgesehen. Die Umlenkung 11 ist in der Zwischenscheibe auf Höhe des Querstegs 16 angeordnet. Die Umlenkung 11 bildet somit einen Kanalabschnitt in der Zwischenscheibe aus, die den Quersteg 16 überbrückt, so dass das Fluid um den Quersteg 16 herum fließen kann.

Fig. 6b zeigt einen Längsschnitt des in Fig. 1 gezeigten Elektronikkühlers durch die Kanäle im zweiten Kanalblech. Gezeigt ist ein Kanal im zweiten Kanalblech, der durch einen Quersteg 16 unterbrochen ist. Eine Umlenkung 11 ist in der Zwischenscheibe für den Quersteg 16 im Kanal des ersten Kanalblechs vorgesehen.

Die Aussparungen 11 in dem Zwischenblech sind der Geometrie und Lage der Längs- und Querstege 16 der Kanalbleche entsprechend gestaltet.

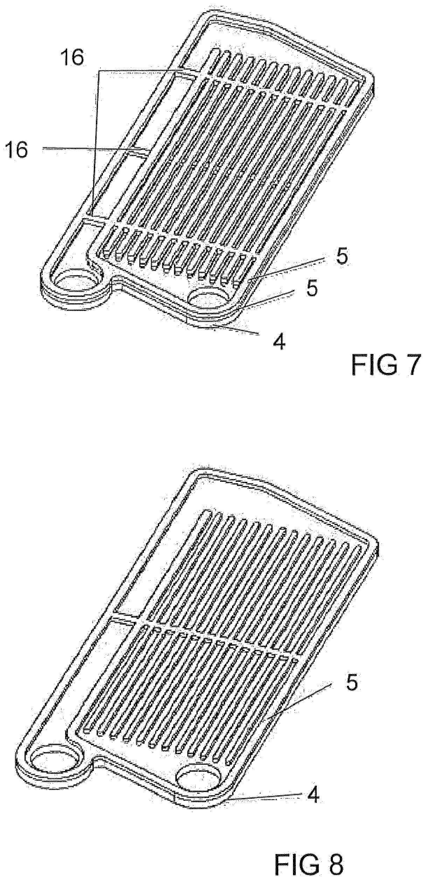

Die Figuren 7 bis 9 zeigen Darstellungen von Elektronikkühlern, gemäß einem Ausführungsbeispiel der vorliegenden Erfindung. Gezeigt ist eine I-Flow Variante mit zwei unterschiedlichen Kanalblechen, ohne Zwischenblech. Bei dieser Variante werden die Längskanäle in zwei übereinander gestapelten Kanalblechen, die miteinander gelötet wurden, gebildet. Sowohl die Längsstege als auch die Randstege bilden im Bereich der Trennfläche Absätze, sogenannte "offsets", die zu einer besseren Verlötung führen.

Fig. 7 zeigt eine I-Flow Variante eines Elektronikkühlers, gemäß einem Ausführungsbeispiel der vorliegenden Erfindung ohne Zwischenblech. Gezeigt ist eine ISO Ansicht von oben zum ersten und zum zweiten Kanalblech 5. Ein oberer Deckel, zum Abschließen des oben angeordneten Kanalblechs 5 und zum Bereitstellen der Wärmeübertragungsfläche ist nicht gezeigt. Dagegen ist ein unterer Deckel 4 gezeigt. Querstege 16 sind im ersten und zweiten Kanalblech 5 vorgesehen. Die Querstege 16 sind für die Fertigung notwendig und sind wegen einer besseren Durchströmung zueinander versetzt angeordnet. Das erste Kanalblech 5 weist zwei Querstege 16 auf, die zum Randbereich der Längsstege des ersten Kanalblechs 5 hin verschoben sind. Das zweite Kanalblech 5 weist einen Quersteg 16 auf, die mittig in Bezug auf die Längsstege des zweiten Kanalblechs 5 angeordnet ist. Die Querstege 16 verbinden Längsstege der Kanalbleche 5. Zwischen zwei benachbart angeordneten Längsstegen wird jeweils ein Kühlkanal ausgebildet. Die Kühlkanäle sind an einem ersten Ende mit einem ersten Sammelbereich und auf einem gegenüberliegenden zweiten Ende mit einem zweiten Sammelbereich verbunden. Auf diese Weise ist eine Flussrichtung des Fluids in allen Fluidkanälen gleich.

Fig. 8 zeigt eine ISO Ansicht des in Fig. 7 gezeigten Kühlers von oben zum zweiten Kanalblech 5. Ferner ist der untere Deckel 4 gezeigt. Der Quersteg ist wie beim ersten Kanal für die Fertigung notwendig und dient auch zur Festigung des Kanalbleches vor der Montage. Im unteren Kanalblech 5 können mehrere Querstege eingebaut werden, unter der Voraussetzung dass diese zu den Stegen im oberen Kanalblech versetzt angeordnet werden.

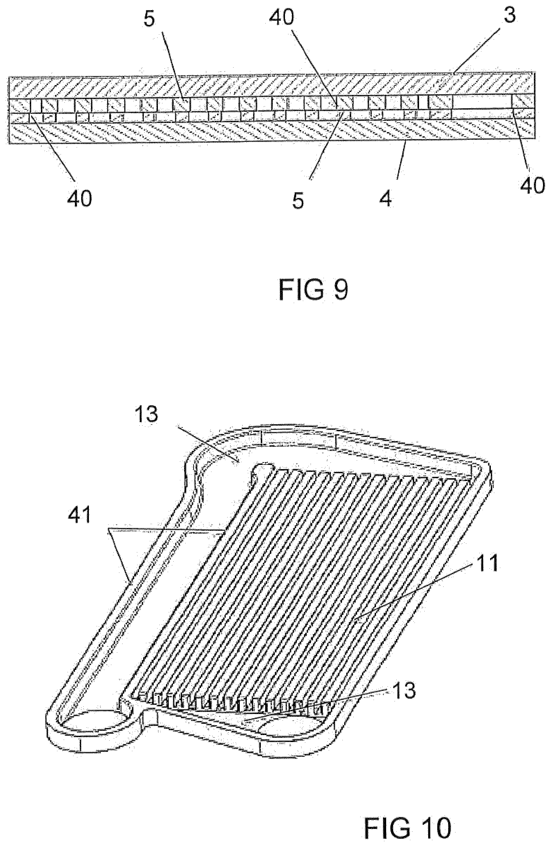

Fig.9 zeigt einen Querschnitt durch die Kanäle des in Fig. 7 gezeigten Kühlers. Gezeigt ist der obere Deckel 3, der untere Deckel 4, das an den oberen Deckel 3 angrenzende erste Kanalblech 5 und das an den unteren Deckel 4 sowie an das erste Kanalblech 5 angrenzende zweite Kanalblech 5. Durch die unterschiedlichen Stegbreiten im ersten und zweiten Kanalblech 5 bilden sich sogenannte "offsets" 40, die zu einer besseren Verlötung führen. Gezeigt sind am linken und am rechten Rand Offsets 40 zwischen den Umlaufstegen. Die Umlaufstege bilden eine seitliche Begrenzung der Kanalbleche 5. Ferner sind Offsets 40 zwischen den Längsstegen gezeigt. Gemäß diesem Ausführungsbeispiel sind die Längsstege des zweiten Kanalblechs 5 mittig zu den Längsstegen des ersten Kanalblechs 5 angeordnet, so dass beidseitig Absätze 40 entstehen.

Figur 10 zeigt eine Darstellung von Elektronikkühlern, gemäß einem weiteren Ausführungsbeispiel. Gezeigt ist eine ISO einer I-Flow Variante mit einer Kanalplatte als Gussteil in einer Ansicht von oben ohne Deckel. Bei dieser Variante werden Deckel und Kanalblech in einem Teil gefertigt. Gezeigt sind Längskanäle 11, ein in Fig. 10 unten gezeigter Sammelkanal ein 13 und ein links dargestellter Sammelkanal aus 13 sowie eine Lotfläche 41, jeweils auf der Oberseite der Stege der Kanalplatte. Bei diesem Ausführungsbeispiel der Kanalplatte als Gussteil wird der Kühler aus zwei Teilen gefertigt. Zum einen aus der in Fig. 10 gezeigten Kanalplatte für die Durchströmung des Kühlfluids und zum anderen aus einem oberen Deckel wo die Leistungselektronik gesintert wird.

Durch Modifikation des Sinterprozesses können auch andere Aluminiumlegierungen eingesetzt werden. Gleichfalls ist dann die genaue Einhaltung des Breiten-Höhenverhältnisses nicht mehr notwendig.

Dies trifft beispielsweise auf das in Fig. 10 gezeigte Ausführungsbeispiel als auch auf ein als Stanzfließpressteil ausgeführtes Kanalblech zu.

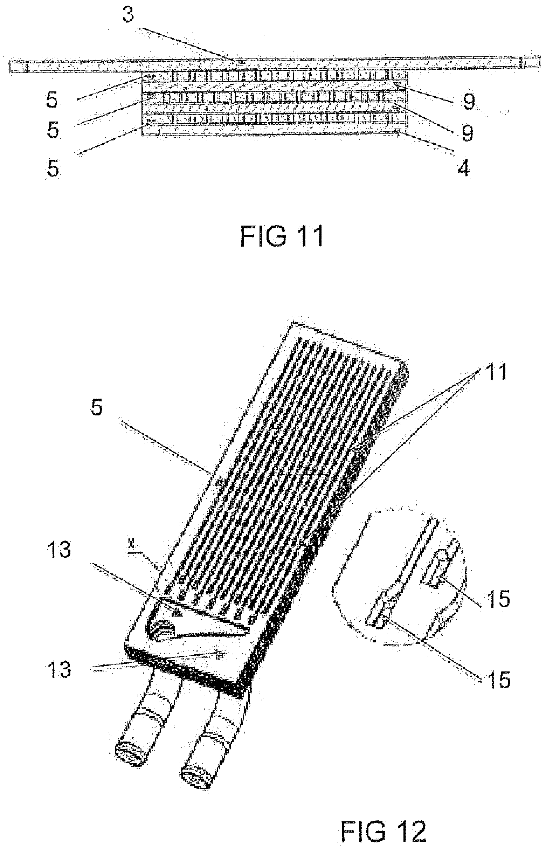

Die Figuren 11 bis 16 zeigen Darstellungen von Elektronikkühlern, gemäß einem weiteren Ausführungsbeispiel. Gezeigt ist eine U- Flow Variante mit drei unterschiedlichen Kanalblechen und zwei Zwischenblechen, die eine Art Grundbaustein bilden. Die Anzahl dieser Kanäle ist von der Höhe des Massenstroms und dem zulässigen Druckabfall abhängig. Die Kanäle sind um eine halbe Teilung versetzt, damit der Kraftfluss im durch den Sinterprozess kraft-beaufschlagten Bereich immer durch die Stege geht und so eine lokale Verformung des Deckels während des Sinterns verhindert wird. Die Teile können z.B. durch Stanzen, Laserstrahl-Schneiden, Wasserstrahl-Schneiden oder Ähnliches gefertigt werden.

Fig. 11 zeigt eine U-Flow Variante eines Elektronikkühlers, gemäß einem Ausführungsbeispiel im Querschnitt durch den Kühler im Kanalbereich. Der Elektronikkühler weist einen Stapelaufbau auf. Von oben nach unten sind ein oberer Deckel 3, ein erstes Kanalblech 5, ein erstes Zwischenblech 9, ein zweites Kanalblech 5, ein zweites Zwischenblech 9, ein drittes Kanalblech 5 und ein unterer Deckel 4 gezeigt. Die Längsstege im zweiten Kanalblech 5, das mittig angeordnet ist, sind gegenüber dem ersten und dem dritten Kanalblech 5 um eine halbe Teilung seitlich versetzt.

Fig. 12 zeigt eine ISO des in Fig. 11 gezeigten Kühlers von oben auf das erste Kanalblech 5. Gezeigt sind ein Sammelkanal ein 13 und eine Position eines verdeckten Sammelkanals aus 13. Gemäß diesem Ausführungsbeispiel sind keine Querstege notwendig, so dass die Kanäle 11 nicht unterbrochen sind. Querstege sind im Sinterbereich für die Fertigung nicht notwendig, da die Umlenkung der U-Flows von dem ersten Kanalblech 5 in das darunter befindliche erste Zwischenblech erfolgt. Fig. 12 zeigt ferner eine Detailansicht des ersten Kanalblechs an der Position x, in der ein U-Flow-Rücklauf 15 und ein U-Flow-Vorlauf 15 gezeigt sind.

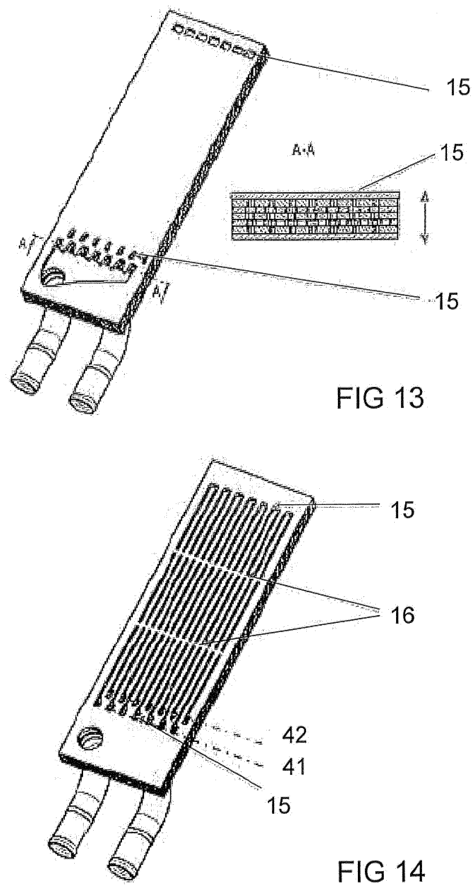

Fig. 13 zeigt eine ISO des in Fig. 11 gezeigten Kühlers von oben auf das erste Zwischenblech. Gezeigt sind im vorderen Bereich Durchleitungen 15 der U-Flow-Rückläufe vom ersten Kanalblech und im hinteren Bereich Umlenkungen 15 der U-Flows von dem ersten Kanalblech. Ausgehend vom Sammelkanal EIN verteilt sich das Fluid im gezeigten ersten Zwischenblech zunächst horizontal auf eine bestimmte Anzahl von Vorlauffluten 15, hier z.B. 7 Fluten. Anschließend werden die Vorlauffluten nochmals vertikal in die drei Kanalebenen verteilt, wie es in dem Schnittbild gezeigt ist, das einen Schnitt entlang der Linie A-A zeigt. In dem Schnittbild ist die vertikale Verteilung der U-Flow-Vorläufe gezeigt.

Fig. 14 zeigt eine ISO des in Fig. 11 gezeigten Kühlers von oben auf das zweite Kanalblech. Gezeigt sind im vorderen Bereich Bereiche 15 der vertikalen Verteilung, die zur Verringerung von Druckverlusten breiter ausgeführt sind. In einer vorderen Ebene 41 sind die U-Flow-Vorläufe und in einer dahinterliegenden Ebene 42 sind die U-Flow-Rückläufe angeordnet. In einem hinteren Bereich sind Umlenkungen 15 der U-Flows von dem zweiten Kanalblech gezeigt. Ferner sind zwei Querstege 16 gezeigt, die zwischen den Randstegen verlaufen und die Längsstege miteinander verbinden. Die Umlenkung der U-Flows im zweiten Kanalblech erfolgt in dieser Ebene, weshalb zur Anbindung und Stabilisierung der Trennstege zwischen den Fluten hier Querstege 16 benötigt werden.

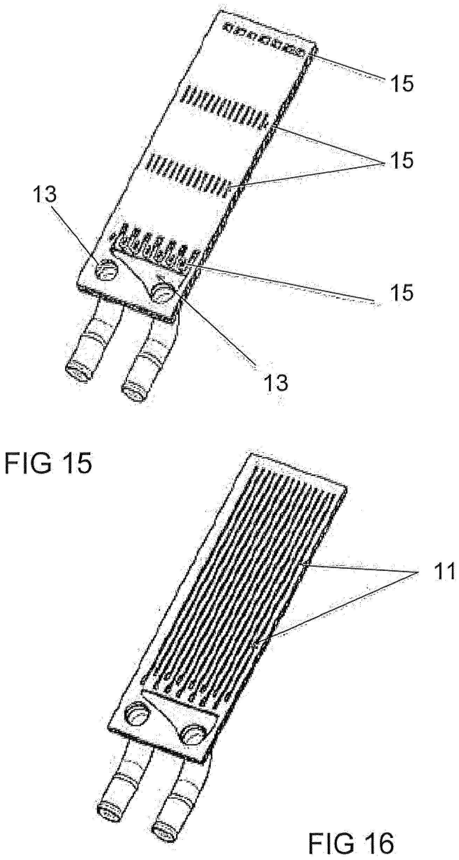

Fig. 15 zeigt eine ISO des in Fig. 11 gezeigten Kühlers von oben auf das zweite Zwischenblech. Gezeigt sind im vorderen Bereich links eine Durchleitung Sammelkanal EIN 13 und rechts ein Sammelkanal AUS 13. Ferner sind im vorderen Bereich Durchleitungen 15 der U-Flow-Vorläufe in das dritte Kanalblech gezeigt. Im hinteren Bereich sind Umlenkungen 15 der U-Flows von dem dritten Kanalblech gezeigt. Im mittleren Bereich sind zwei Reihen von Umlenkungen 15 der U-Flows von dem zweiten Kanalblech gezeigt. Die Rückläufe aller U-Flows werden in dem gezeigten zweiten Zwischenblech zum Sammelkanal AUS 13 zurückgeleitet. Der Sammelkanal AUS 13 wird durch das zweite Zwischenblech und das dritte Kanalblech gebildet, wie es in Fig. 7 gezeigt ist.

Fig. 16 zeigt eine ISO des in Fig. 11 gezeigten Kühlers von oben auf das dritte Kanalblech. Gezeigt sind Kanäle 11, die nicht durch Querstege unterbrochen sind, da diese nicht notwendig sind. Analog zu dem ersten Kanalblech sind Querstege im Sinterbereich für die Fertigung hier nicht notwendig, da die Umlenkung der U-Flows von dem dritten Kanalblech hier im darüber befindlichen zweiten Zwischenblech erfolgt.

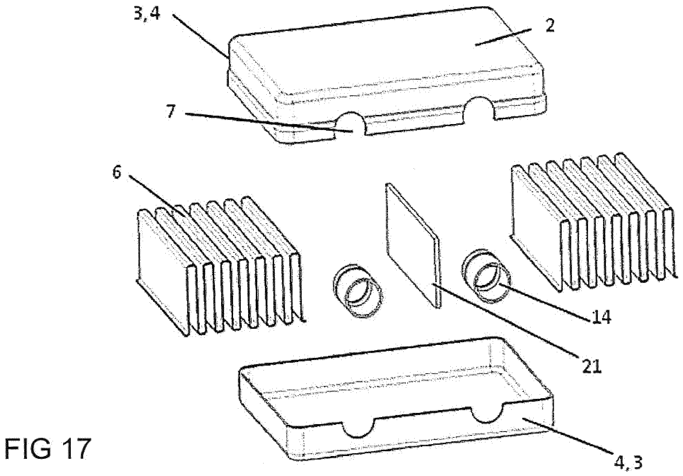

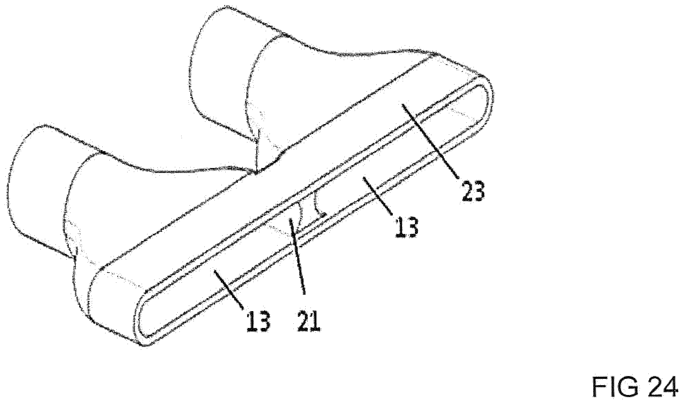

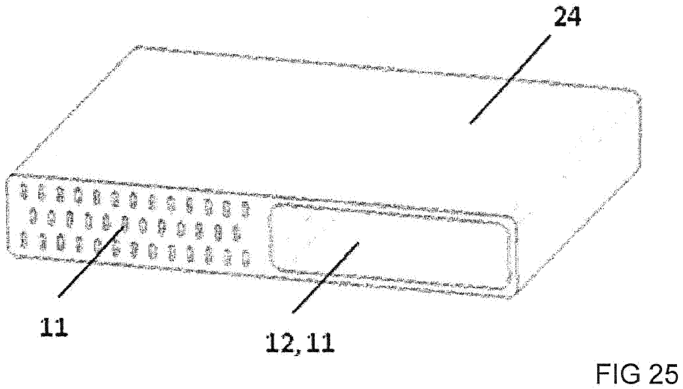

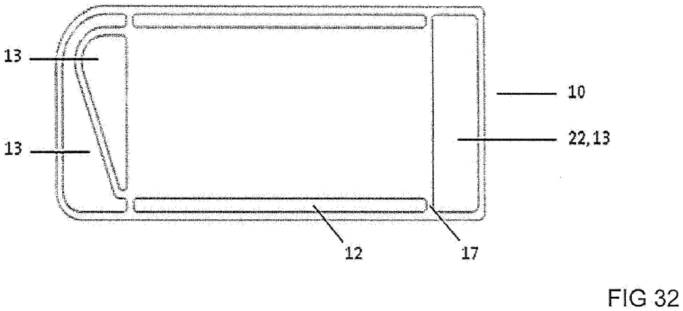

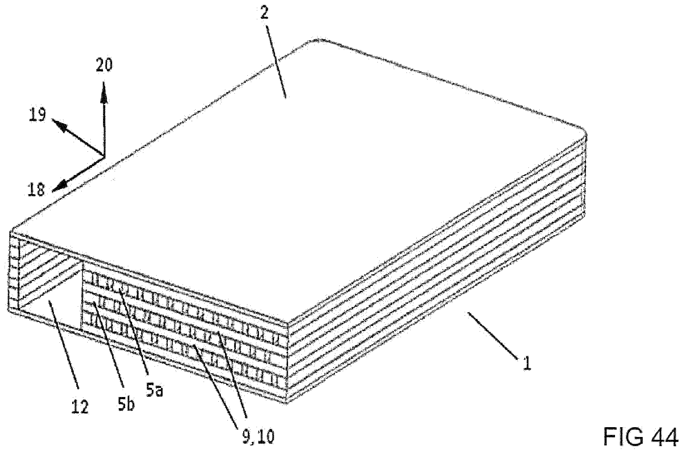

Anhand der Figuren 17 bis 63 sind nachfolgend weitere Ausführungsbeispiele eines Elektronikkühlers gezeigt. Die Elektronikkühler weisen jeweils eine Wärmeübertragungsfläche 2 oder einen Wärmeübertragungsbereich auf. Dies ist eine Fläche zur Anbringung von Elektronikkomponenten, beispielswiese von MOSfets, IGBT's, Transistoren oder allgemein Leistungselektronik oder ähnliches.

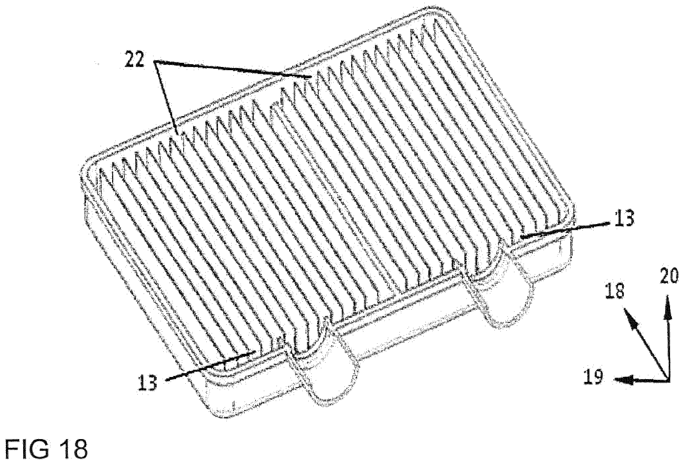

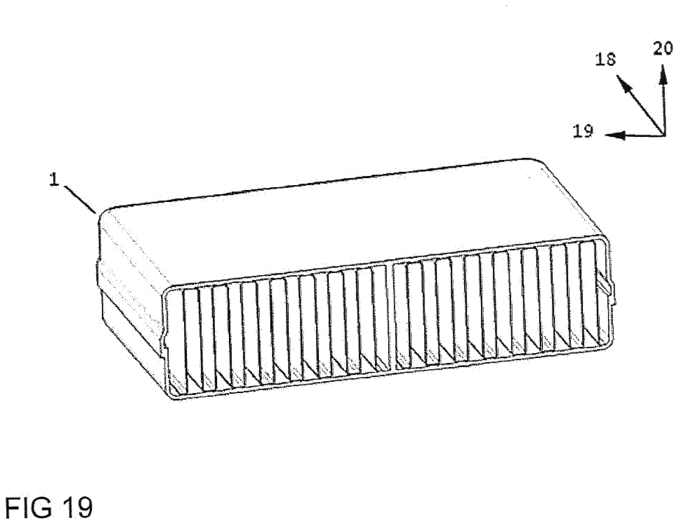

Die Figuren 17 bis 19 zeigen eine Variante A einer Kanaleinlage gemäß einem Ausführungsbeispiel. Fig. 17 zeigt einen Kühler in Explosionsdarstellung, isometrisch und die Figuren 18 und 19 zeigen den Kühler im Querschnitt und im horizontalen Längsschnitt, isometrisch.

Der Deckel 3 und/oder der Boden 4 sind schalenartig gestaltet. Es kann auch nur einer der beiden Komponenten schalenartig gestaltet sein, sodass die andere dann eher flächig eben gestaltet ist. Boden 4 und Deckel 3 werden miteinander kühl- und oder kältemitteldicht gefügt. Dazu kann ein Überfappungsbereich oder Kontaktflächenbereich der beiden Komponenten nach dem Fügen dienen. Auf Boden 4 und/oder Deckel 3 können zu kühlende oder erwärmende Elektronikkomponenten aufgebracht werden. Boden 4 und Deckel 3 bilden einen inneren Hohlraum aus. In diesen Hohlraum werden Kanaleinlagen 6 eingebracht. Die Kanaleinlagen 6 können als Berippung (Vergrößerung Wärmeübertragungsfläche und/oder Turbulenzförderer) und als Abstandshalter zwischen Boden 4 und Deckel 3 dienen. Außerdem können sie innen und außen auftretende Kräfte aufnehmen, die während der Fertigung oder im Betrieb auf den Kühler 1 einwirken. Die Kanaleinlagen 6 können mit Boden 4 und/oder Deckel 3 fest verbunden sein. In Deckel 3 und/oder Boden 4 befinden sich Öffnungen 7 für den Ein- und Austritt des Fluids in den Kühler 1. Die Öffnungen 7 werden mit Anschlussleitungen 14 gefügt. Das Fluid gelangt nach Eintreten in den Kühler 1 zunächst in einen Verteilbereich 13. Anschließend durchströmt es auf einer Seite des Kühlers 1 die Kanäle 11, 6 in positiver Längsrichtung 18. Danach wird es in einem Umlenkbereich 22 umgelenkt, bevor es auf der anderen Seite des Kühlers 1 durch Kanäle 11, 6 wieder in negativer Längsrichtung 18 zurückgeführt wird. Die Umlenkung wird durch eine Trennung 21 der linken und rechten Seite (Breitenrichtung 19) des Kühlers 1 gewährleistet. Die Trennung 21 kann Teil von Boden 4 und/oder Deckel 3 und/oder Kanaleinlage 6 sein. Verzichtet man auf die Trennung 21 (nicht dargestellt) kann der Austritt auf der dem Eintritt gegenüberliegenden Seite vorgesehen werden.

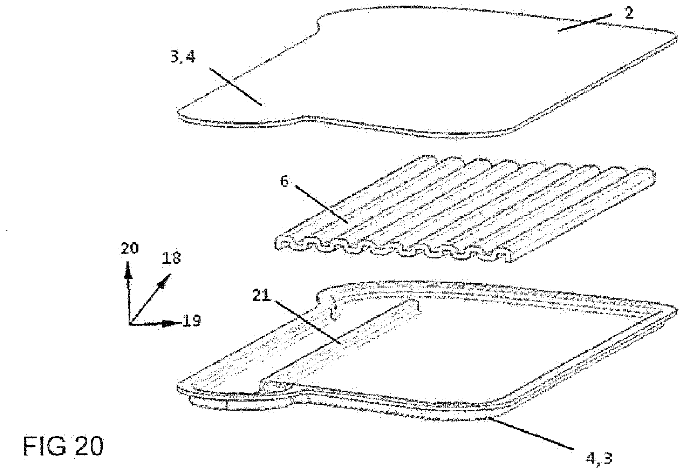

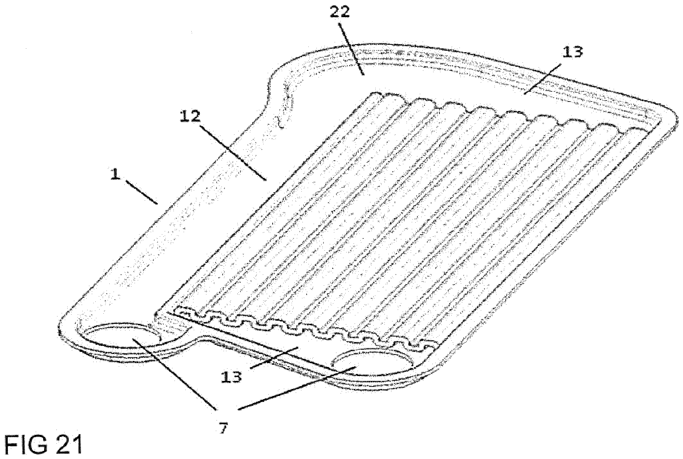

Die Figuren 20 bis 21 zeigen eine Variante B einer Kanaleinlage gemäß einem Ausführungsbeispiel. Fig. 20 zeigt einen Kühler in Explosionsdarstellung, isometrisch und Fig. 21 zeigt den Kühler ohne Deckel, isometrisch.

Die Öffnungen 7 in Deckel 3 und/oder Boden 4 für den Ein- und Austritt des Fluids in den Kühler 1 befinden sich anders als in der in Fig. 17 gezeigten Variante ober-oder unterseitig 2 und nicht seitlich. Das Fluid gelangt nach Eintreten in den Kühler 1 zunächst in einen Verteilbereich 13. Anschließend durchströmt es auf der Hauptseite des Kühlers 1 die Kanäle 11, 6 in positiver Längsrichtung 18. Danach wird es in einem Umlenkbereich 13, 22 wieder gesammelt, bevor es auf der anderen Seite des Kühlers 1 in einem Rückführkanal 12 wieder in negativer Längsrichtung 18 zurückgeführt wird. Linke (Rückführkanal 12) und rechte (Kanaleinlage 6) Seite des Kühlers 1 sind durch eine stegartige Trennung 21 separiert. Die Trennung 21 kann Teil von Boden 4 und/oder Deckel 3 und/oder Kanaleinlage 6 sein. Im Rückführkanal 12 ist keine Kanaleinlage 6 vorgesehen.

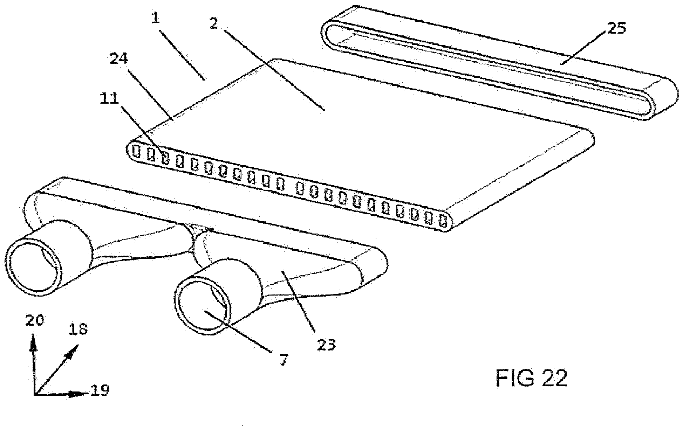

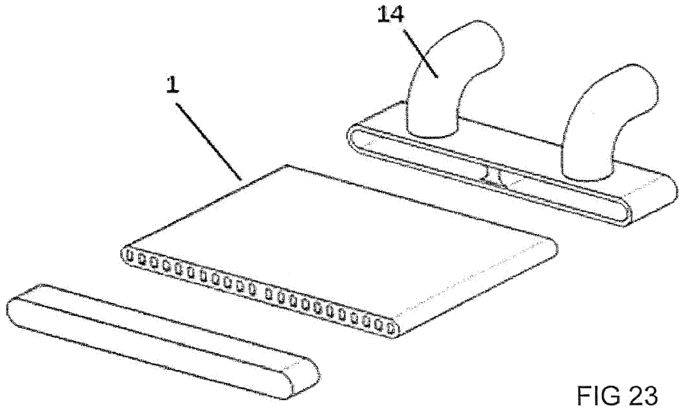

Die Figuren 22 bis 25 zeigen eine Variante C eines Extrusionsprofils. Fig. 22 zeigt einen Kühler in Explosionsdarstellung, isometrisch und die Figuren 23 bis 25 zeigen diverse Ausführungen und Komponenten des Kühlers, isometrisch.

Der Kühler 1 weist einen Anschlusskasten 23, ein Extrusionsprofil 24 mit Kanälen 11 und einen Umlenkkasten 25 auf. Der Anschlusskasten 23 ist mit Öffnungen 7 für den Ein- und Austritt des Fluids ausgeführt und im Inneren in zwei Sammelbereiche 13 aufgeteilt. Daher befindet sich im Anschlusskasten 23 eine Trennung 21 der beiden Bereiche 13. Der Anschlusskasten 23 ist mit dem Extrusionsprofil 24 gefügt. Das Fluid tritt vom Eintritts-Sammelbereich 13 des Anschlusskastens 23 in die Kanäle 11 der entsprechenden Seite (in Breitenrichtung 19) des Extrusionsprofils 24 ein. Auf der anderen Seite (in Längsrichtung 18) des Extrusionsprofil 24 ist dieses mit dem Umlenkkasten 25 gefügt. Im Umlenkkasten 25 wird das Fluid erneut gesammelt und der anderen Seite (in Breitenrichtung 19) des Extrusionsprofil 24 zugeführt, bevor es in dem oder den Kanälen wieder in negativer Längsrichtung 18 zum Austritts-Sammelbereich 13 des Anschlusskastens 23 zurückströmt. Die zu kühlenden Elektronikkomponenten befinden sich auf der Ober- und/oder Unterseite (in Höhenrichtung 20) des Extrusionsprofils 24. Die Kanäle 11 des Extrusionsprofils 24 können mehrlagig und auch zueinander versetzt angeordnet werden. Die Kanäle 11 selbst können rund oder eckig sein. Die Öffnungen 7 im Anschlusskasten 23 für den Ein- und Austritt können in Längs 18- Breiten 19- oder Höhenrichtung 20 weisen. Die Rückführung des Fluids kann auch anwendungsbedingt entfallen, sodass der Austritt auf der dem Eintritt gegenüberliegenden Seite (in Längsrichtung 18) vorgesehen werden kann.

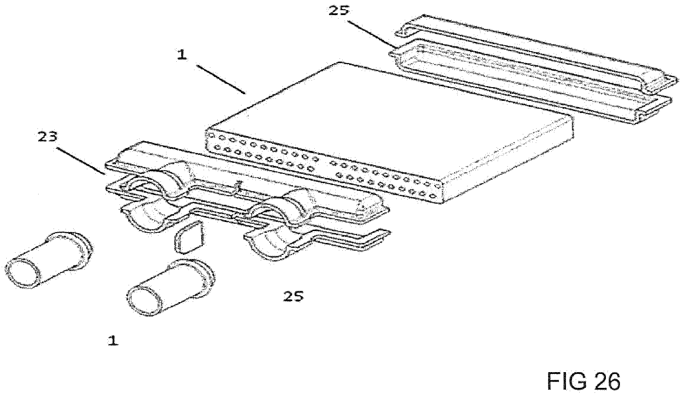

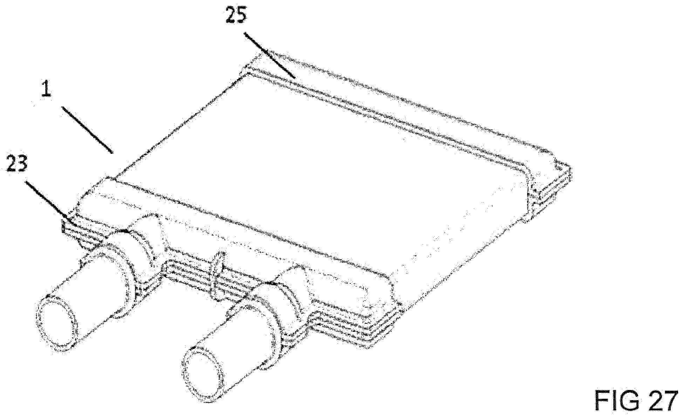

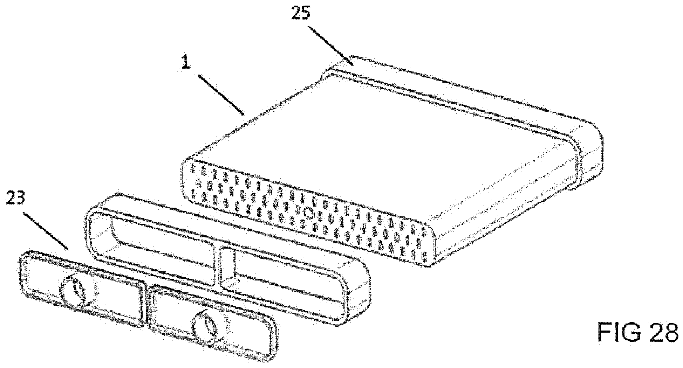

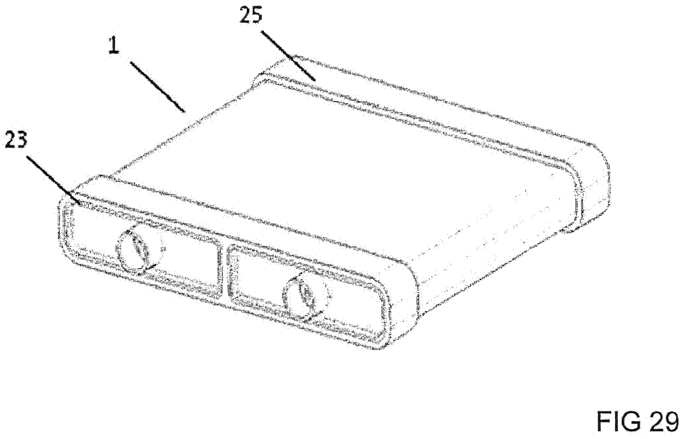

Die Figuren 26 bis 29 zeigen eine Variante D eines Extrusionsprofils gemäß einem Ausführungsbeispiel. Die Figuren 26 und 28 zeigen diverse Ausführungen des Kühlers in Explosionsdarstellung, isometrisch. Die Figuren 27 und 29 zeigen diverse Ausführungen des Kühlers, isometrisch.

Siehe hierzu auch Variante C. Die Anschlusskästen 23 und Umlenkkästen 25 sind auf verschiedene Weise herstellbar, z. B. als Druckguss-, Fließpress-, Extrusions-, oder Stanz/ Umformteil. Auch können sie ein- oder mehrteilig aufgebaut sein.

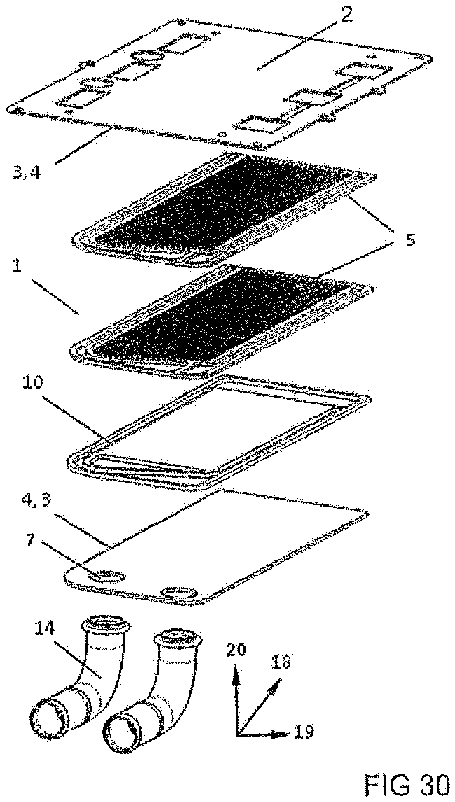

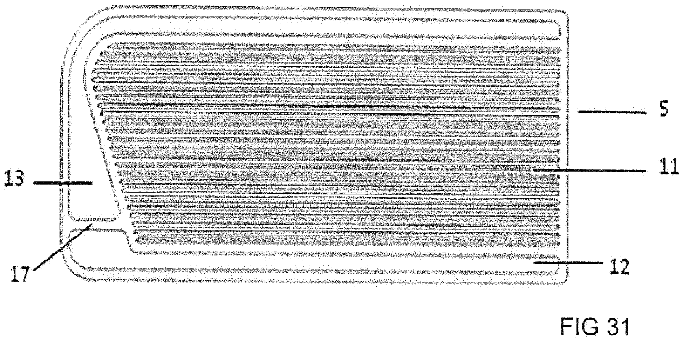

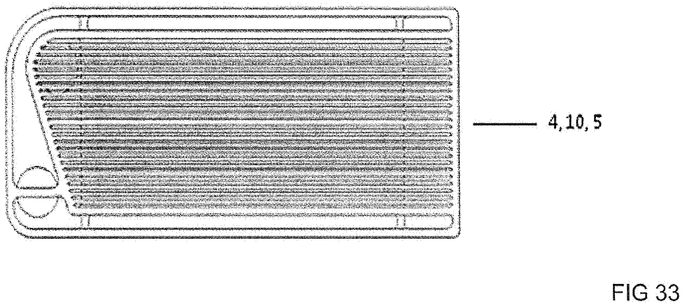

Die Figuren 30 bis 33 zeigen eine Variante E eines Kanalblechs gemäß einem Ausführungsbeispiel. Fig. 30 zeigt einen Kühler in Explosionsdarstellung, isometrisch und die Figuren 31 bis 32 zeigen ein Kanal- und Verteilblech des Kühlers einzeln und Fig. 33 zeigt diese im Zusammenbau mit Boden (unten), jeweils als Draufsicht.

Der Kühler 1 besteht aus (in Höhenrichtung 20) übereinander gestapelten oder geschichteten Blechen, die miteinander verbunden sind. Die einzelnen Bleche erfüllen unterschiedliche Aufgaben und können demgemäß Kanalblech 5, Verstärkungsblech 9, Verteilblech 10, Bodenblech 4 oder Deckelblech 3 sein. Diese verschiedenen Bleche können in unterschiedlicher Anzahl und Ausführung im Kühler 1 verbaut sein oder ggf. ganz entfallen. Auf dem Deckel- und/oder Bodenblech 3, 4 werden die elektronischen Komponenten aufgebracht. Deckel- und/oder Bodenblech 3, 4 begrenzen somit den Kühler 1 nach oben und unten (in Höhenrichtung 20). Deckel und/oder Boden 3, 4 weisen Öffnungen 7 für den Ein- und Austritt des Fluids auf. Dem Deckel und/oder Boden 3,4 folgt ein Verteilblech 10. Das Verteilblech 10 weist einen Eintritts-Sammelbereich 13 auf, in welchen das Fluid eingeleitet wird. Der Sammel/-Verteilbereich 13 ist (in Breitenrichtung 19) so gestaltet, dass eine optimale Massenstromverteilung gewährleistet wird. Dem Verteilblech 10 folgt ein Kanalblech 5. Vom Eintritts-Sammelbereich 13 des Verteilblechs 10 gelangt das Fluid in die Kanäle 11 des Kanalblechs 5 und durchläuft dort (in Längsrichtung 18) den Wärmeübertragungsbereich 2 des Kühlers 1. Je nach Auslegung des Kühlers 1 (Leistung, Druckabfall etc.) kann es erforderlich sein mehrere Verteil 10- und/oder Kanalbleche 5 einzubringen. Anschließend wird das Fluid wieder in einem Umlenkungs-Sammelbereich 22, 13 des Verteilblechs 10 zusammengeführt, bevor es in einem seitlichen Rückführkanal 12 des Kanal 5- und/oder Verteilblechs 10 außerhalb oder innerhalb des Wärmeübertragungsbereichs 2 wieder (in Längsrichtung 18) zurückgeführt wird. Der Rückführkanal 12 kann zweigeteilt und somit in der Breite 19 beidseitig angeordnet sein, wenn dies anwendungsbedingt erforderlich ist. Ein weiterer Austritt-Sammelbereich 13 im Kanal 5-und/oder Verteilblech 10 führt das Fluid aus den Rückführkanälen 12 zusammen und kommuniziert mit der Austrittsöffnung 7 im Boden 4 oder Deckel 3. Das Verteilblech 10 kann im Bereich der Wärmeübertragungsstrecke 2 massiv ausgeführt sein, und somit als Verstärkungs-Wandung 9 für Boden 4 und/oder Deckel 3 dienen, wenn entsprechende Kräfte auf den Kühler 1 einwirken. Auch kann das Verteilblech 10 Aussparungen 8, 11 (nicht dargestellt) im Wärmeübertragungsbereich 2 aufweisen, die als Ergänzung zu den Kanälen 11 im Kanalblech 5 dienen können. Kanal 5- und/oder Verteilblech 10 weisen an diversen Stellen Versteifungsstege 17 auf, um die filigrane Stanz-Innenkontur der Bleche 5, 10 zu halten und/oder zu unterstützen. Zwischen den Kanalblechen 5 können Verstärkungsbleche 9 eingebracht werden, wenn dies aus Festigkeitsgründen erforderlich ist. Die Verstärkungsbleche 9 sind im Bereich der Kanäle 11 des angrenzenden Kanalbleches 5 massiv ausgeführt. Die Verstärkungsbleche 9 können Verteilbereiche 10, Umlenkbereiche 22 und Rückführkanäle 12 aufweisen.

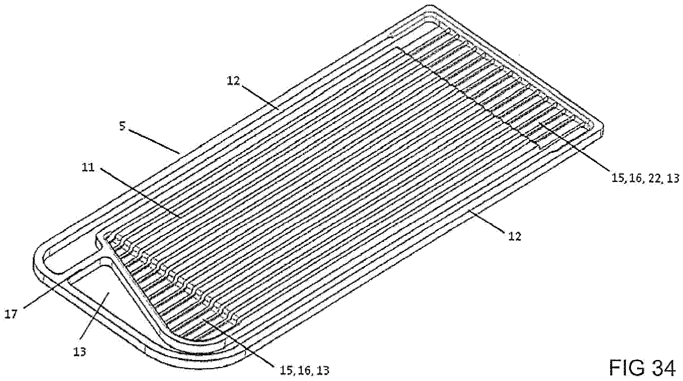

Fig. 34 zeigt eine Variante F eines Kanalblechs gemäß einem Ausführungsbeispiel, isometrisch.

Siehe hierzu auch die Variante E. Um die Druckabfälle im Sammel/- Verteilbereich 13 des Kühlers 1 zu reduzieren, bzw. um eventuell ganz auf ein Verteilblech 10 verzichten zu können, wird ein Sammel/-Verteilbereich 13 im Kanalblech 5 über eine Vertiefung /Prägung 15 eingebracht. Die Kanäle 11 sind hier 13 jedoch noch in Form von Haltestegen 16 vorhanden. Die Stege zwischen den Kanälen 11 sind somit über die Haltestege 16 mit dem restlichen Kanalblech 5 verbunden. Die Rückführung 12 ist bei dieser Variante exemplarisch beidseitig angeordnet.

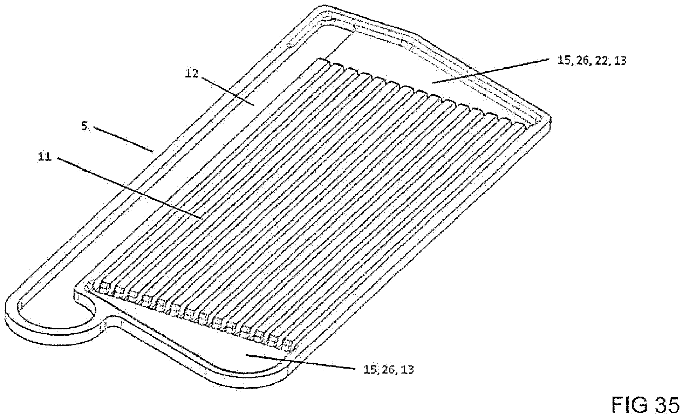

Fig. 35 zeigt eine Variante G eines Kanalblechs gemäß einem Ausführungsbeispiel, isometrisch.

Siehe hierzu auch die Varianten E und F. Die Kanäle 11 enden vor den Sammelbereichen 13 und die Kanal-Stege gehen gemeinsam auf jeder Seite in Längsrichtung 18 in eine Halteplatte 26 über. Die Stege zwischen den Kanälen 11 sind somit über die beiden Halteplatten 26 mit dem restlichen Kanalblech 5 verbunden. Die Rückführung 12 ist bei dieser Variante exemplarisch einseitig angeordnet.

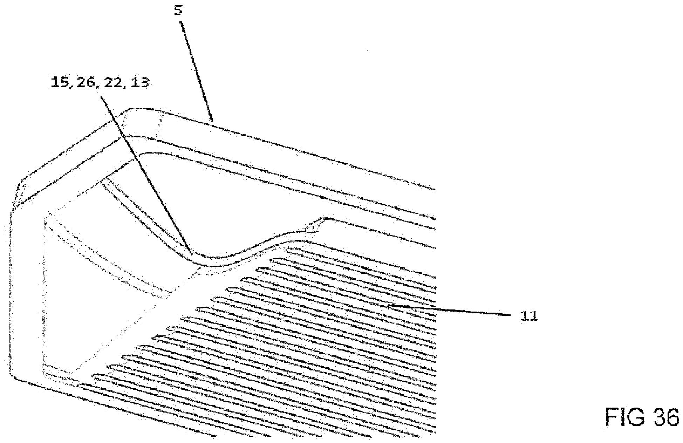

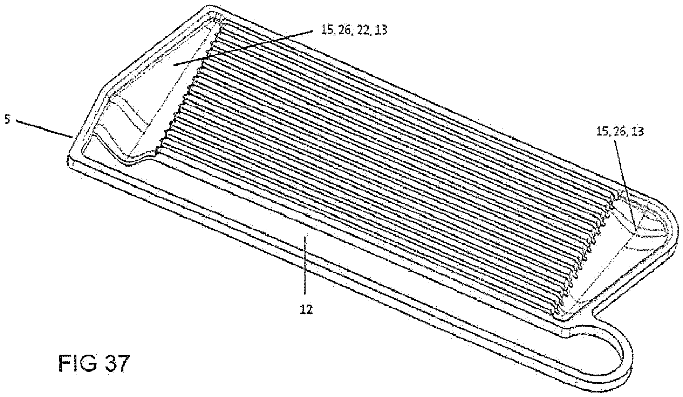

Die Figuren 36 bis 37 zeigen eine Variante H eines Kanalblechs gemäß einem Ausführungsbeispiel. Fig. 36 zeigt einen Kanalblech-Ausschnitt im Verteilbereich von unten, isometrisch. Fig. 37 zeigt ein Kanalblech von oben, isometrisch.

Siehe hierzu auch Variante G. Die eingebrachte Vertiefung /Prägung 15 überragt das Kanalblech in Höhenrichtung 20 um noch mehr Fluid-Volumen im Verteilbereich 13 zu schaffen.

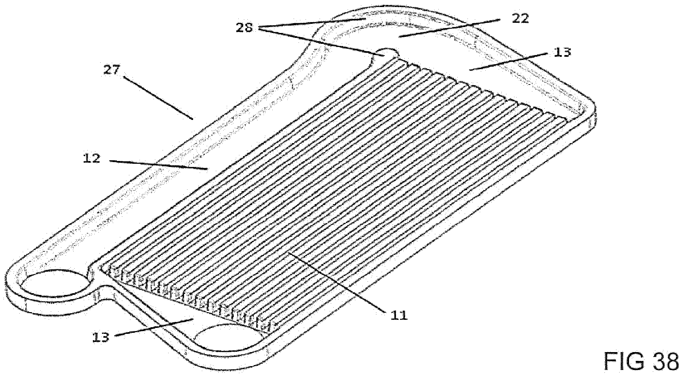

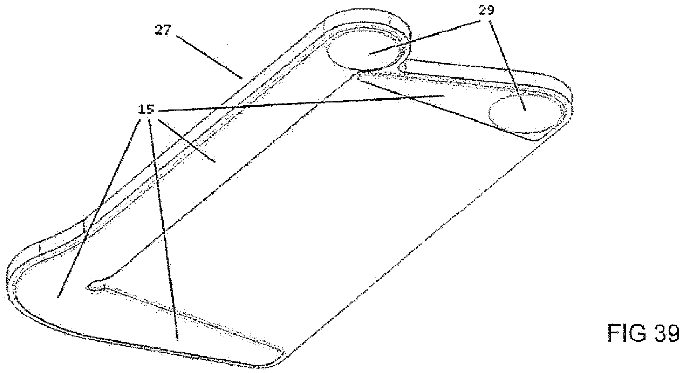

Die Figuren 38 bis 39 zeigen eine Variante I eines Kanalblechs gemäß einem Ausführungsbeispiel. Fig. 38 zeigt ein Kanalblech von oben, isometrisch. Fig. 39 zeigt ein Kanalblech von unten, isometrisch.

Siehe hierzu auch die Varianten E bis H. Um beispielsweise die Teilezahl eines Kühlers 1 zu reduzieren kann man Boden 4 und Kanalblech 5 oder Deckel 3 und Kanalblech 5 zu einem einzigen Teil 27 zusammenfassen. Dieses Teil 27 ist einseitig vollständig verschlossen, auch im Bereich des Rückführkanals 12. Auf der anderen Seite sind die bereits beschriebenen Kanalblech 5-Merkmale abgebildet. Dieses Kombinationsteil 27 ist wie die Varianten F-H neben Kanalblech 5 und Boden/Deckel 4,3 auch Verteilblech 10. Zur Reduzierung des Druckabfalls können insbesondere die Sammelbereiche 13, der Umlenkbereich 22 und der Rückführkanal 12 gegenüber dem herkömmlichen Blechniveau erhaben bzw. vertieft 15 sein, wodurch sich vergrößerte Strömungsquerschnitte ergeben. Die Strömungsführung im Umlenkbereich 22 ist optimiert 28: Kontinuierlicherer Strömungsquerschnitts-Verlauf entlang der Strömung und dadurch weniger Verwirbelungen in der Strömung. Ein- und Austrittsöffnungen 7 können vorgesehen werden. In diesem Öffnungsbereich können zusätzliche Ausprägungen 29 vorgesehen werden, um auch hier einen kontinuierlicheren Übergang von Blechströmung in die Rohrströmung der verbundenen Anschlussleitungen 14 zu finden, wodurch auch hier der Druckabfall weiter verringert werden kann.

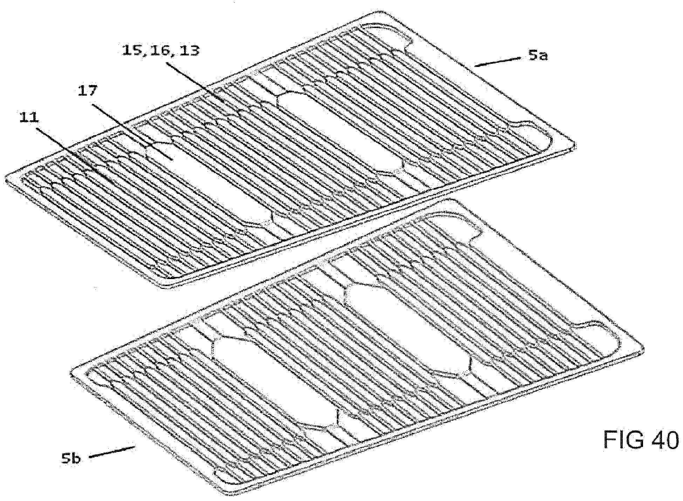

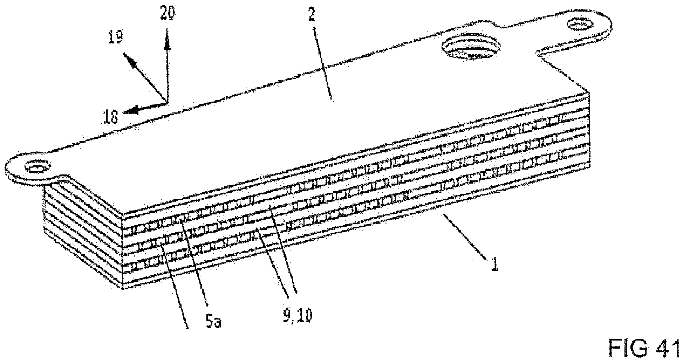

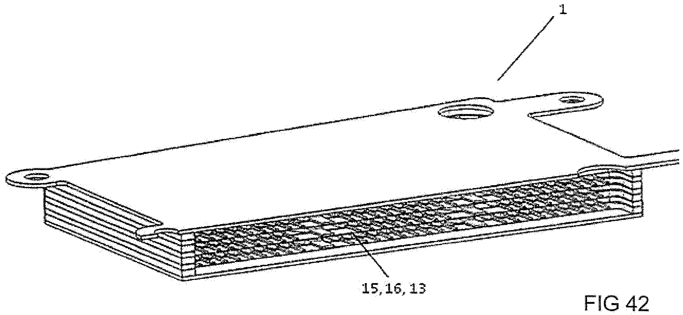

Die Figuren 40 bis 42 zeigen eine Variante J eines Kanalblechs gemäß einem Ausführungsbeispiel Fig. 40 zeigt Kanalbleche, isometrisch. Die Figuren 41 und 42 zeigen Längsschnitte des Kühlers, isometrisch.

Das Kanalblech 5 wird hier nicht längs 18 durchströmt, sondern in der Breite 19. Das Teil 5 benötigt daher keinen separaten Rückführkanal 12, wenn Ein- und Austritt auf der gleichen Seite in Längsrichtung 18 liegen sollen. Ein- und Austritt kann beliebig auf der einen oder anderen Seite in Längsrichtung 18 positioniert werden. Der Kühler 1 benötigt aus Gründen der Strömungsführung kein Verteilblech 10, wenn zwei oder mehr unterschiedliche Kanalbleche 5a, b verbaut werden, wobei dann deren Kanäle 11 versetzt zueinander angeordnet sind. Da die Stege der Kanäle 11 im Sammel/-Verteilbereich 13 in Haltestege 16 übergehen, kann durch die versetzte Anordnung eine Durchströmung des Verteilbereichs 13 in Längsrichtung 18 ermöglicht werden. Die Stege der Kanäle 11 können aus Festigkeitsgründen auch als Versteifungsstege 17 ausgeführt werden. Die Haltestege 16 können ein-oder beidseitig in Höhenrichtung 20 geprägt, und somit erniedrigt werden. Die Haltestege 16 können zudem schmäler (in Längsrichtung 18) als die Stege der Kanäle 11 ausgeführt werden.

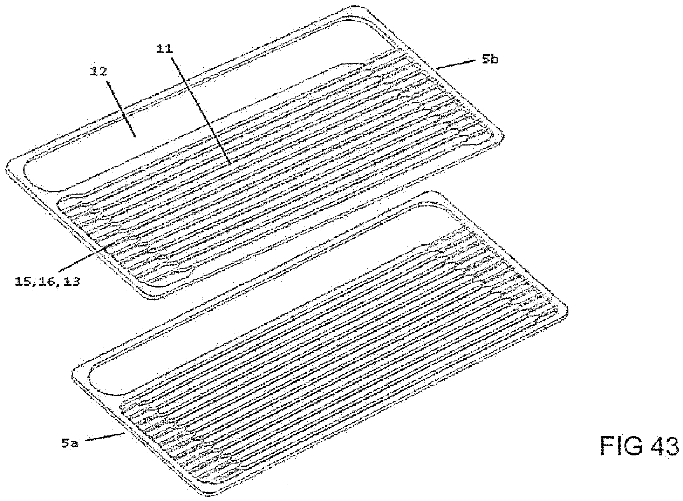

Die Figuren 43 bis 44 zeigen eine Variante K eines Kanalblechs gemäß einem Ausführungsbeispiel. Fig. 43 zeigt Kanalbleche, isometrisch. Die Figuren 41 und 42 zeigen Längsschnitte des Kühlers, isometrisch.

Siehe hierzu auch die Variante J. Variante K ist wie die Varianten E bis I längs 18 durchströmt.

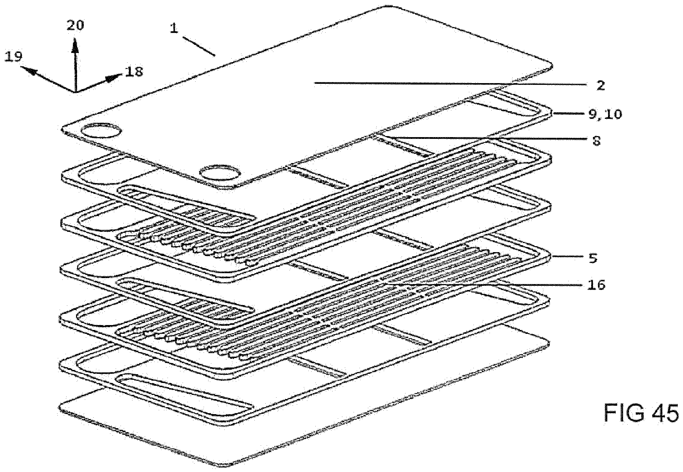

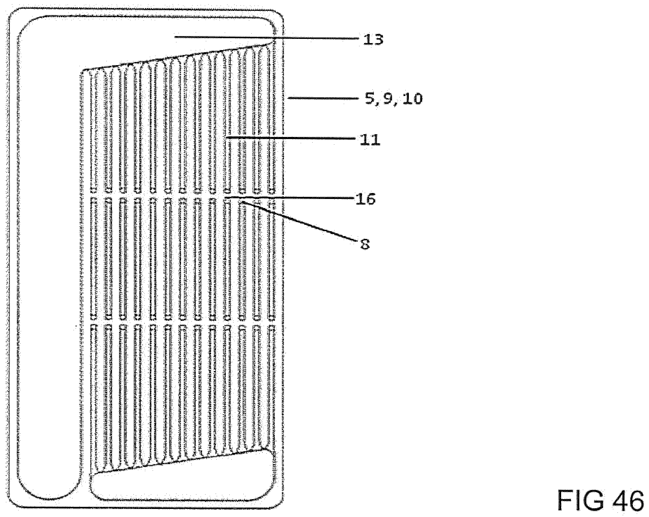

Die Figuren 45 bis 46 zeigen eine Variante L eines Kanalblechs gemäß einem Ausführungsbeispiel. Fig. 45 zeigt einen Kühler in Explosionsdarstellung, isometrisch. Fig. 46 zeigt ein Kanalblech des Kühlers im Zusammenbau mit Verstärkungs-/Verteilblech als Draufsicht.

Siehe hierzu auch die Variante K. Anders als die vorhergegangenen Varianten weisen die Kanalbleche 5 der Variante L keine längsgerichteten 18 Haltestege 16 als Fortführung der Stege der Kanäle 11 im Verteilbereich 13 auf. Die Stege der Kanäle 11 und das restliche Kanalblech 5 sind hier miteinander in der Breite 19 an einem oder mehreren Haltestegen 16 im Wärmeübertragungsbereich 2 verbunden. Um eine Durchströmung der Kanäle 11 zu gewährleisten, können die Haltestege 16 entweder erniedrigt bzw. geprägt/vertieft 15 (nicht dargestellt) werden, oder die den Kanalblechen 5 benachbarten Verteil- 10 oder Verstärkungsblechen 9 sind im Bereich der Haltestege 16 der Kanalbleche 5 entsprechend ausgespart 8. Somit kann das Fluid im Bereich der Haltestege 16 der Kanalbleche 5 in die Aussparungen 8 der Verteil- 10 oder Verstärkungsbleche 9 übertreten, und nach Überwindung Haltestege 16 der Kanalbleche 5 wieder in die Kanäle 11 der Kanalbleche 5 eintreten. Es können auch hier zwei oder mehr unterschiedliche Kanalbleche 5a, b verbaut werden, wobei dann deren Kanäle 11 versetzt zueinander angeordnet sind.

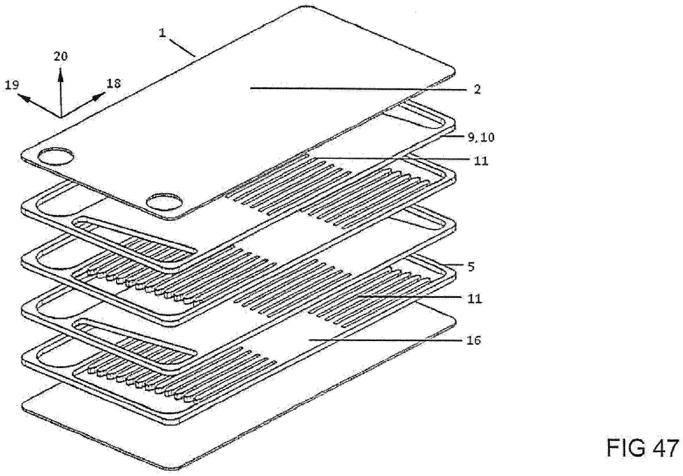

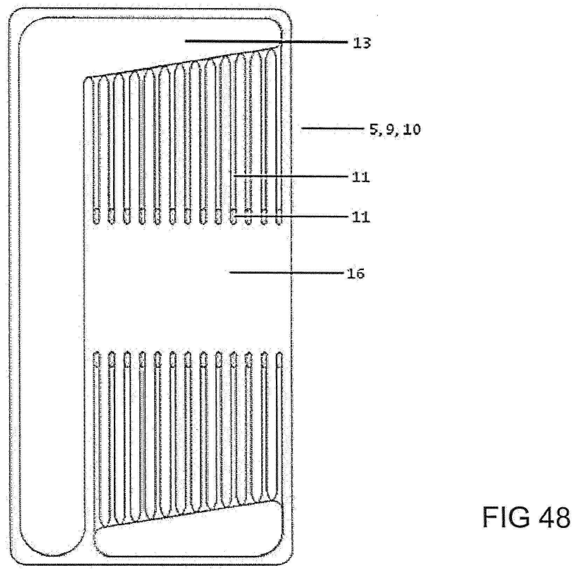

Die Figuren 47 bis 48 zeigen eine Variante M eines Kanalblechs gemäß einem Ausführungsbeispiel. Fig. 47 zeigt einen Kühler in Explosionsdarstellung, isometrisch. Fig. 48 zeigt ein Kanalblech des Kühlers im Zusammenbau mit Verstärkungs-/Verteilblech als Draufsicht.

Siehe hierzu auch die Variante L. Der Haltesteg 16 des Kanalblechs 5 bei Variante M ist ungleich breiter ausgeführt als bei Variante L. Um den Kühler 1 in seiner Festigkeit in diesem Bereich 16, 11, 2 nicht zu sehr zu schwächen, werden statt einer Aussparung 8 Kanäle 11 in das Verstärkungs-/Verleilblech 9, 10 eingebracht, die mit den Kanälen 11 der benachbarten Kanalbleche 5 überlappen, sodass ein Übertritt des Fluids von Kanalblech 5 zu Verstärkungs-/Verteilblech 9, 10 und umgekehrt stattfinden kann. Das Verstärkungs-Nerteilblech 9, 10 gleicht daher in diesem Abschnitt 16 einem Kanalblech 5.

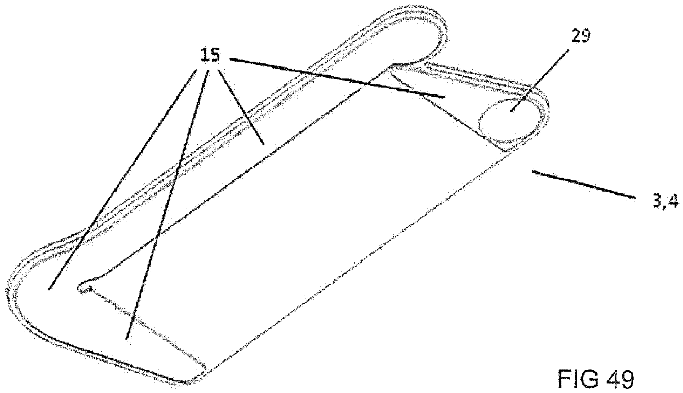

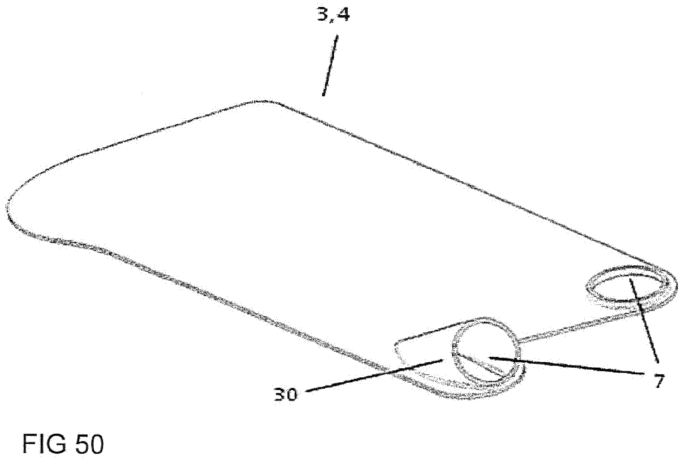

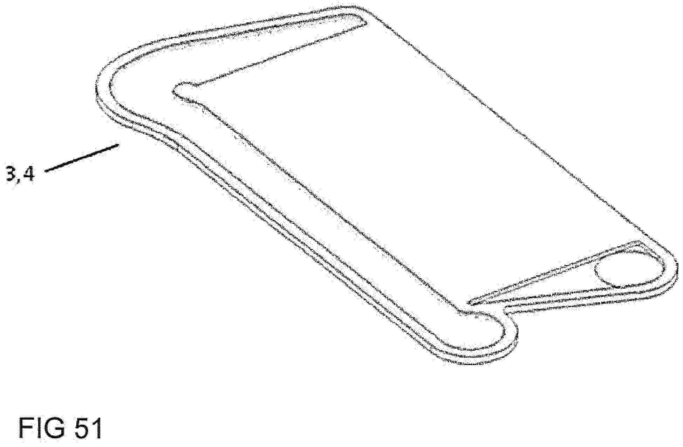

Die Figuren 49 bis 51 zeigen eine Variante N eines Bodens oder Deckels gemäß einem Ausführungsbeispiel. Die Figuren 49 und 51 zeigen den Boden bzw. Deckel von oben und von unten, isometrisch. Fig. 50 zeigt den Boden bzw. Deckel, isometrisch.

Zur Reduzierung des Druckabfalls können Boden 4 und/oder Deckel 3 im Bereich der Sammelbereiche 13, der Umlenkbereiche 22 und der Rückführkanäle 12 der benachbarten Kanalbleche 5 gegenüber dem herkömmlichen Blechniveau erhaben bzw. vertieft 15 sein, wodurch sich vergrößerte Strömungsquerschnitte im Kühler 1 ergeben. Im Bereich der Öffnungsbereiche der benachbarten Bleche 5 können zusätzliche Ausprägungen 29 vorgesehen werden, um auch hier einen kontinuierlicheren Übergang von Kühlerströmung in die Rohrströmung der verbundenen Anschlussleitungen 14 zu finden, wodurch auch hier der Druckabfall weiter verringert werden kann. Zu diesem Zwecke kann die Öffnung 7 in Boden 4 oder Deckel 3 auch mit einem Durchzug 30 versehen werden, welcher in einem Winkel kleiner 90° vom Blech 3, 4 absteht.

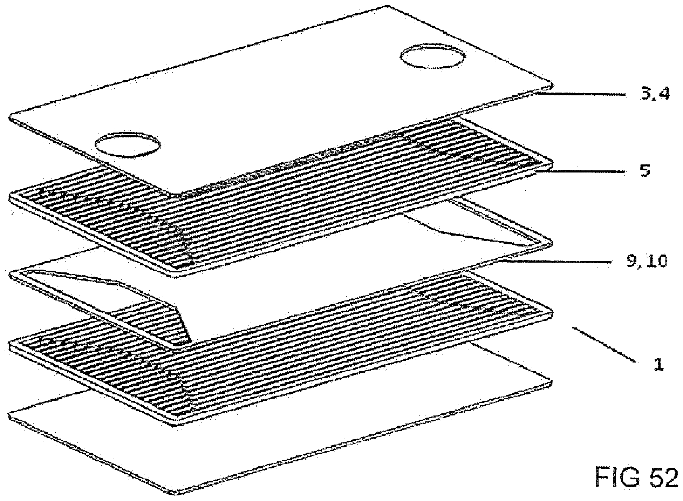

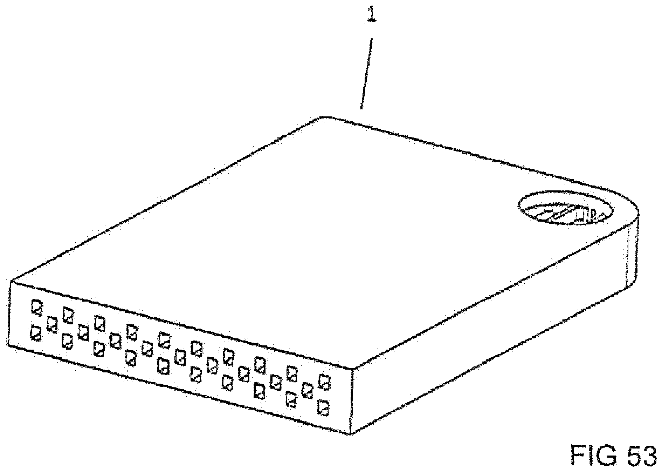

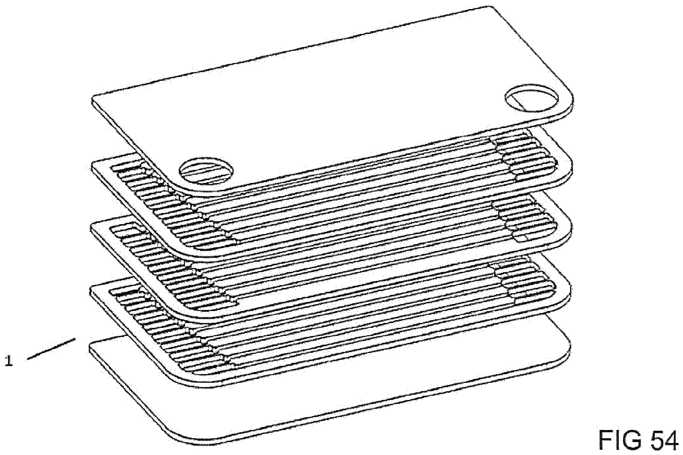

Die Figuren 52 bis 54 zeigen eine Variante O eines Kanalblechs gemäß einem Ausführungsbeispiel. Die Figuren 52 und 54 zeigen einen Kühler in Explosionsdarstellung, isometrisch. Fig. 53 zeigt ein Kühler im Querschnitt, isometrisch.

Siehe hierzu auch die Variante K. Variante O weist keine Rückführung 12 auf.

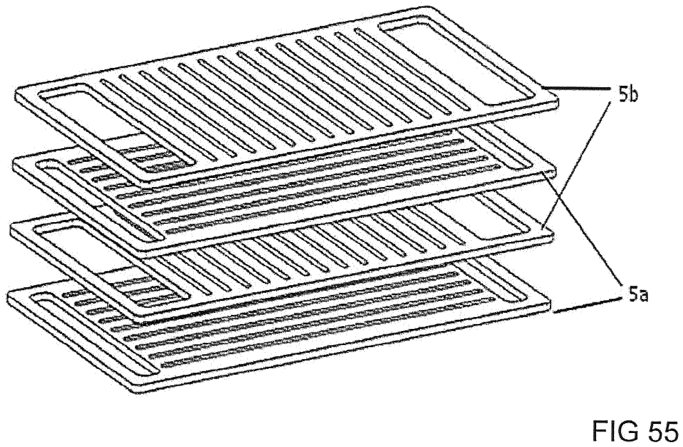

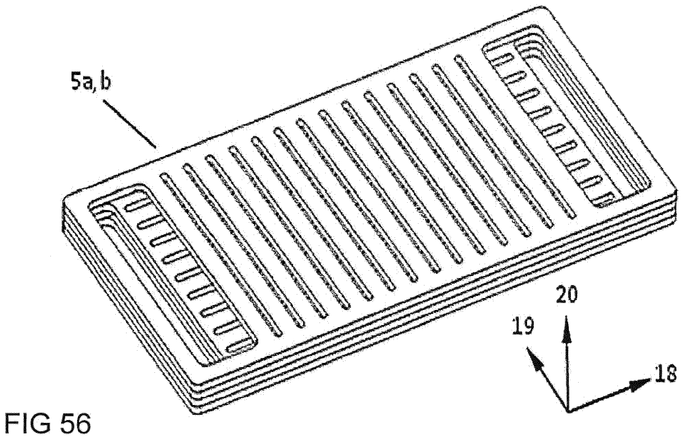

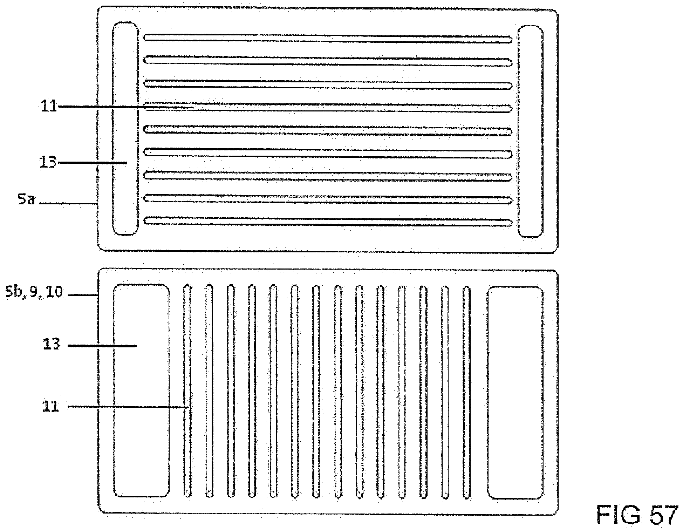

Die Figuren 55 bis 57 zeigen eine Variante P eines Kanalblechs gemäß einem Ausführungsbeispiel. Die Figuren 55 und 56 zeigen Kanalbleche des Kühlers in Explosionsdarstellungen und geschichtet, isometrisch. Fig. 57 zeigt Kanalbleche des Kühlers als Draufsicht.

Zwei unterschiedliche Kanalbleche 5a, b werden abwechselnd geschichtet. Die Kanäle 11 des ersten Kanalblech-Typs 5a verlaufen in Längsrichtung 18 und sind zum Verteilbereich 13 hin beabstandet, weshalb keine Haltestege 16 der Stege der Kanäle 11 erforderlich sind. Der Verteilbereich 13 ist in Längsrichtung 18 relativ schmal ausgeführt. Die Kanäle 11 des zweiten Kanalblech-Typs 5b verlaufen in Breitenrichtung 19. Zusätzliche Haltestege 16 der Stege der Kanäle 11 sind auch hier nicht erforderlich. Der Verteilbereich 13 ist hier in Längsrichtung 18 relativ breit ausgeführt. Durch die unterschiedlichen Breiten der Verteilbereiche 13 der beiden Blech-Typen 5a, b), können die ersten Kanalblech-Typen 5a vom Verteilbereich 13 des Kühlers 1 ausgehend mit einem Fluid beaufschlagt werden. Das Einbringen von Kanälen 11 in den zweiten Kanalblech-Typ 5b ist nicht zwingend erforderlich. Verzichtet man beispielsweise aus Festigkeitsgründen hierauf (nicht dargestellt), kann der zweite Kanalblech-Typ 5b gänzlich als Verteil 10- oder Verstärkungsblech 9 dienen.

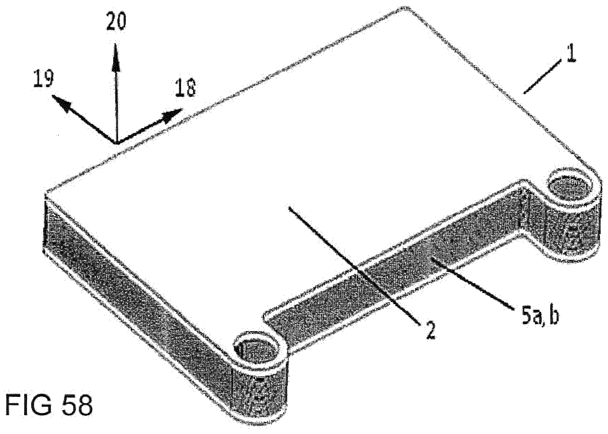

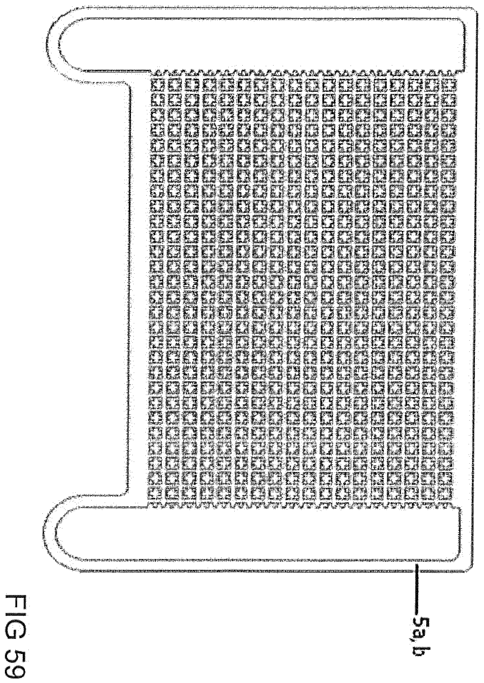

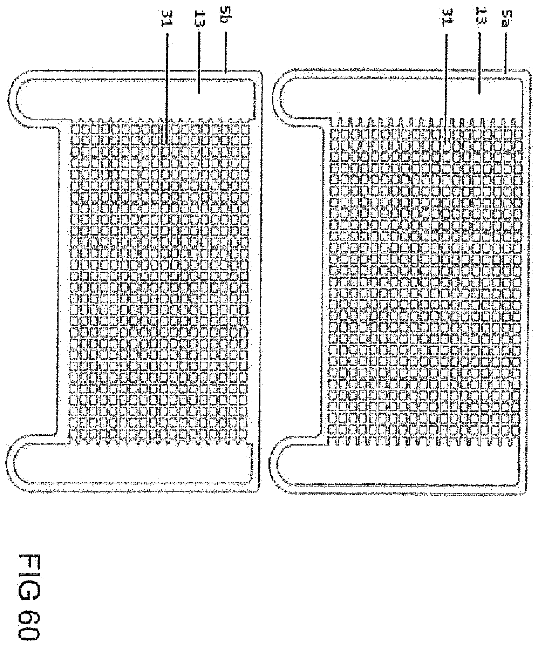

Die Figuren 58 bis 60 zeigen eine Variante Q eines Lochgitterblechs gemäß einem Ausführungsbeispiel. Die Fig. 58 zeigt einen Kühler, isometrisch. Die Fig. 59 zeigt Kanalbleche des Kühlers geschichtet in Draufsicht. Die Fig. 60 zeigt Kanalbleche des Kühlers als Draufsicht.

Siehe hierzu auch Variante P. Die beiden Kanalblech-Typen 5a, b sind im Wärmeübertragungs-Bereich 2 Lochgitter-artig 31 gestaltet. Das Lochgitter 31 des ersten Kanalblech-Typ 5a ist bezüglich des Lochgitters 31 des zweiten Kanalblech-Typ 5b in der Breite 19 und in der Länge 18 versetzt. Dadurch kann ein Fluid den Kühler 1 durchströmen, indem es abwechselnd vom Kanalblech-Typ 5a zum Kanalblech-Typ 5b und umgekehrt übertritt. Zu den Verteilbereichen 13 hin sind die beiden Lochgitter 31 der beiden Typen 5a, b offen. Die Verteilbereiche 13 der beiden Typen 5a, b können in Längsrichtung 18 gleich breit sein.

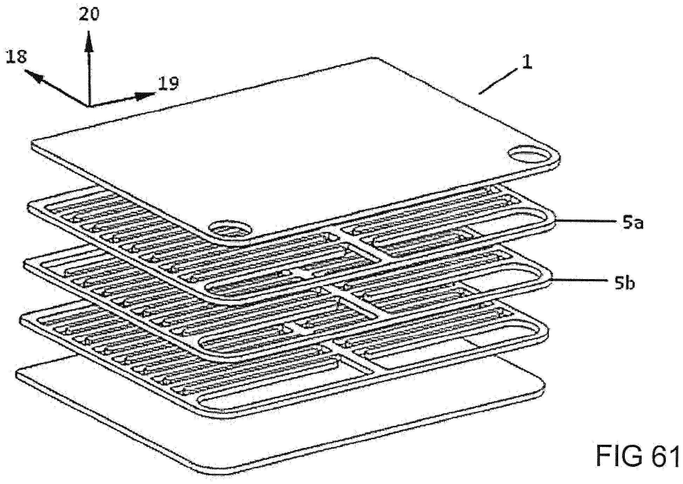

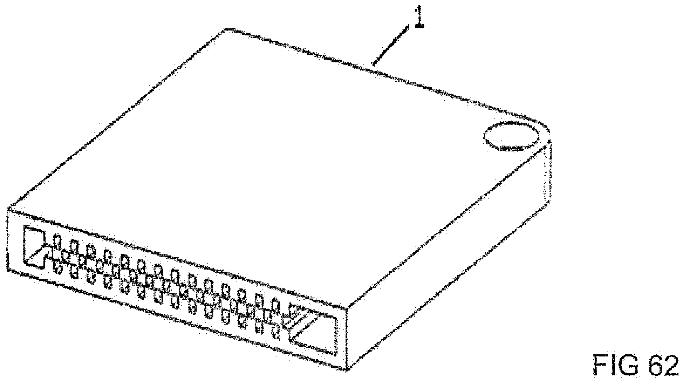

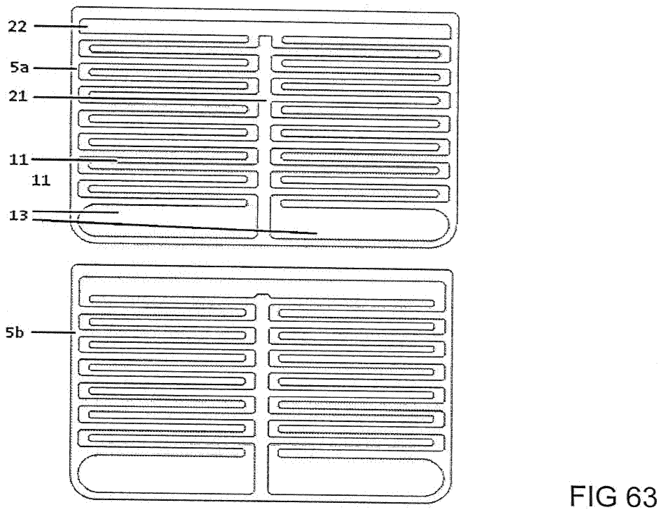

Die Figuren 61 bis 63 zeigen eine Variante R eines Kanalblechs gemäß einem Ausführungsbeispiel. Die Fig. 61 zeigt einen Kühler in Explosionsdarstellung. Die Fig. 62 zeigt einen Kühler im Längsschnitt, isometrisch. Die Fig. 63 zeigt Kanalbleche des Kühlers als Draufsicht.

Siehe hierzu auch die vorangegangenen Varianten. Das Fluid gelangt nach Eintreten in den Kühler 1 zunächst in einen Verteilbereich 13. Anschließend durchströmt es auf einer Seite des Kühlers 1 die Kanäle 11 der Kanalbleche 5 schlängelnd in positiver Längsrichtung 18. Danach wird es in einem Umlenkbereich 22 umgelenkt, bevor es auf der anderen Seite des Kühlers 1 durch weitere Kanäle 11 wieder in negativer Längsrichtung 18 zurückgeführt wird. Die Umlenkung wird durch eine Trennung 21 der linken und rechten Seite (Breitenrichtung 19) des Kühlers 1 gewährleistet. Die Kanäle 11 des Kanalbleches 5 sind beiderseitig schlängelnd angelegt. Die Stege der Kanäle 11 sind daher abwechselnd mit der Trennung 21 und der Außenumrandung des Kanalbleches 5 verbunden. Verzichtet man auf die Trennung 21 (nicht dargestellt), kann der Austritt auf der dem Eintritt gegenüberliegenden Seite vorgesehen werden. Es können unterschiedliche Kanalbleche 5a, b geschichtet werden, deren Kanäle 11 aus Festigkeitsgründen versetzt zueinander angeordnet werden.

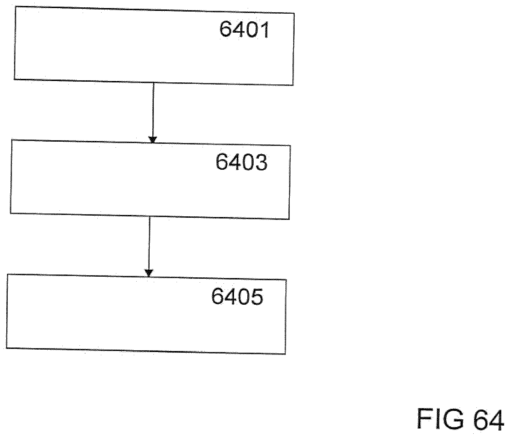

Fig. 64 zeigt ein Ablaufdiagramm eines Verfahrens zum Herstellen eines Elektronikkühlers, gemäß einem Ausführungsbeispiel der vorliegenden Erfindung.

In einem Schritt 6401 wird ein Kühlkörper bereitgestellt, der eine Mehrzahl von Fluidkanälen und eine Wärmeübertragungsfläche aufweist. Der Kühlkörper kann gemäß einem der vorangegangenen Ausführungsbeispiele aufgebaut sein. Die Wärmeübertragungsfläche des Kühlkörpers und der gesamte Kühlkörper sind zum Aufsintern mindestens eines Elektronikbauteils geeignet. Besteht der Kühlkörper aus mehreren Einzelteilen, so kann er bereits fertig montiert und, abgesehen von dem noch fehlenden Elektronikbauteil, einsatzbereit sein. In einem Schritt 6403 wird das mindestens eine Elektronikbauteil bereitgestellt. In einem Schritt 6405 wird das mindestens eine Elektronikbauteil mit einem geeigneten Sinterverfahren auf der Wärmeübertragungsfläche befestigt.

Die beschriebenen Ausführungsbeispiele sind nur beispielhaft gewählt und können miteinander kombiniert werden.

### Bezugszeichenliste

- 1: Elektronikkühler
- 2: Wärmeübertragungsfläche
- 3: Deckel (-Blech)
- 4: Boden (-Blech)
- 5: Kanalblech
- 6: Kanal-Einlage (auch Turbulenzblech, Einlege-Rippen)
- 7: Öffnung (z.B. für Ein- und Austritt)
- 8: Aussparung
- 9: Verstärkungsblech
- 10: Verteilblech
- 11: Kanal
- 12: Rückführkanal
- 13: Sammelbereich = Ein-/Ausström-Kammer vor und nach Kanäle
- 14: Anschlussleitung
- 15: Ausprägung
- 16: Haltesteg Kanal
- 17: Versteifungssteg
- 18: Längenrichtung
- 19: Breitenrichtung
- 20: Höhenrichtung
- 21: Trennung (z.B. Steg)
- 22: Umlenkung
- 23: Anschlusskasten
- 24: Extrusionsprofil
- 25: Umlenkkasten
- 26: Halteplatte
- 27: Boden und Kanalblech oder Deckel und Kanalblech
- 28: Optimierte Strömungsführung im Umlenkbereich
- 29: Zusätzliche Ausprägung im Bereich der Öffnungen
- 30: Durchzug
- 31: Lochgitter
- 40: Offset
- 41: vordere Ebene
- 42: hintere Ebene
- 6401: Verfahrensschritt
- 6403: Verfahrensschritt
- 6405: Verfahrensschritt

## Patentansprüche

1. Elektronikkühler, mit folgendem Merkmal:
einem Kühlkörper (1), der eine Mehrzahl von Fluidkanälen (11) und eine Wärmeübertragungsfläche (2) zum Aufsintern mindestens eines Elektronikbauteils aufweist, und
**dadurch gekennzeichnet, dass** der Kühlköper (1) einen Schichtaufbau aus mindestens einem Kanalblech (5) zum Ausformen der Mehrzahl von Fluidkanälen (11) und einen Deckel (3) aufweist und die Wärmeübertragungsfläche (2) eine Oberfläche des Deckels ist, und
der Kühlkörper ein erstes Kanalblech (5) und ein zweites Kanalblech (5) aufweist, wobei durch das erste Kanalblech ausgeformte Fluidkanäle (11) entlang ihrer Längsrichtung jeweils mit durch das zweite Kanalblech ausgeformten Fluidkanäle verbunden sind, wobei die durch das erste Kanalblech ausgeformten Fluidkanäle sich in ihrer Breite von den durch das zweite Kanalblech ausgeformten Fluidkanälen unterscheiden.

2. Elektronikkühler gemäß Anspruch 1, der das mindestens eine Elektronikbauteil aufweist, das auf der Wärmeübertragungsfläche (2) aufgesintert ist.

3. Elektronikkühler gemäß einem der vorangegangenen Ansprüche, bei dem der Kühlkörper (1) ein Material und eine geometrischer Struktur aufweist, die auf einen beim Aufsintern auf die Wärmeübertragungsfläche (2) wirkenden Druck und auf eine beim Aufsintern auf die Wärmeübertragungsfläche (2) wirkende Temperatur ausgelegt sind.

4. Elektronikkühler gemäß einem der vorangegangenen Ansprüche, bei dem eine Höhe der Mehrzahl von Fluidkanälen (11) jeweils dem einfachen bis zweifachen einer Breite der Mehrzahl von Fluidkanälen entspricht, wobei sich die Höhe im Wesentlichen orthogonal und die Breite im Wesentlichen parallel zu einer Haupterstreckungsebene der Wärmeübertragungsfläche (2) erstreckt.

5. Elektronikkühler gemäß einem der vorhergehenden Ansprüche, bei dem der Kühlkörper (1) ein erstes Kanalblech (5) und ein zweites Kanalblech (5) aufweist, wobei durch das erste Kanalblech ausgeformte Fluidkanäle (11) und durch das zweite Kanalblech ausgeformte Fluidkanäle versetzt zueinander angeordnet sind.

6. Verfahren zum Herstellen eines Elektronikkühlers nach einem der vorhergehenden Ansprüche, das den folgenden Schritt umfasst:
Aufsintern (6405) mindestens eines Elektronikbauteils auf eine Wärmeübertragunsfläche (2) eines Kühlkörpers (1), der eine Mehrzahl von Fluidkanälen (11) und die Wärmeübertragungsfläche zum Aufsintern des mindestens einen Elektronikbauteils aufweist.

7. Verwendung eines Sinterverfahrens zum Aufsintern mindestens eines Elektronikbauteils auf eine Wärmeübertragungsfläche (2) eines Kühlkörpers (1) eines Elektronikkühlers nach einem der Ansprüche 1 bis 5, der eine Mehrzahl von Fluidkanälen (11) und die Wärmeübertragungsfläche zum Aufsintern des mindestens einen Elektronikbauteils aufweist.

## Claims

1. An electronics cooler, having the following feature:
a cooling body (1) having a plurality of fluid channels (11) and a heat transfer surface (2) for sintering thereon at least one electronics component, and **characterised in that** the cooling body (1) has a layer structure from at least one channel plate (5) for forming the plurality of fluid channels (11), and a cover (3), and the heat transfer surface (2) is a surface of the cover, and the cooling body has a first channel plate (5) and a second channel plate (5), wherein fluid channels (11) formed by the first channel plate are connected along their longitudinal direction in each case to fluid channels formed by the second channel plate, wherein the fluid channels formed by the first channel plate differ from the fluid channels formed by the second channel plate in terms of their width.

2. The electronics cooler according to claim 1, said electronics cooler having the at least one electronics component that is sintered onto the heat transfer surface (2).

3. The electronics cooler according to one of the preceding claims, the cooling body (1) of which has a material and a geometrical structure that are designed for a pressure acting on the heat transfer surface (2) during sintering, and for a temperature acting on the heat transfer surface (2) during sintering.

4. The electronics cooler according to one of the preceding claims, wherein a height of the plurality of fluid channels (11) corresponds in each case to one to two times a width of the plurality of fluid channels, wherein the height extends substantially orthogonal and the width extends substantially parallel to a main extension plane of the heat transfer surface (2).

5. The electronics cooler according to one of the preceding claims, the cooling body (1) of which has a first channel plate (5) and a second channel plate (5), wherein fluid channels (11) formed by the first channel plate and fluid channels formed by the second channel plate are arranged offset to one another.

6. A method for the production of an electronics cooler according to one of the preceding claims, comprising the following step:
Sintering (6405) at least one electronics component onto a heat transfer surface (2) of a cooling body (1) having a plurality of fluid channels (11) and the heat transfer surface for sintering thereon the at least one electronics component.

7. Use of a sintering method for sintering at least one electronics component onto a heat transfer surface (2) of a cooling body (1) of an electronics cooler according to one of claims 1 to 5, the cooling body having a plurality of fluid channels (11) and the heat transfer surface for sintering thereon the at least one electronics component.

## Revendications

1. Refroidisseur électronique ayant la caractéristique suivante :
un dissipateur de chaleur (1) qui présente une pluralité de conduits de fluide (11) et une surface de transfert de chaleur (2) servant à l'agglomération par frittage d'au moins un composant électronique, et **caractérisé en ce que** le dissipateur de chaleur (1) présente une structure en couches se composant au moins d'une tôle de conduits (5) servant au formage de la pluralité de conduits de fluide (11) et présente un couvercle (3), et la surface de transfert de chaleur (2) est une surface du couvercle, et le dissipateur de chaleur présente une première tôle de conduits (5) et une deuxième tôle de conduits (5), où des conduits de fluide (11) formés par la première tôle de conduits sont reliés, le long de leur direction longitudinales, respectivement à des conduits de fluide formés par la deuxième tôle de conduits, où les conduits de fluide formés par la première tôle de conduits se différencient, dans leur largeur, des conduits de fluide formés par la deuxième tôle de conduits.

2. Refroidisseur électronique selon la revendication 1, qui présente le composant électronique au moins au nombre de un qui est aggloméré par frittage sur la surface de transfert de chaleur (2).

3. Refroidisseur électronique selon l'une des revendications précédentes, dans lequel le dissipateur de chaleur (1) présente un matériau et une structure géométrique qui sont conçus pour une pression agissant sur la surface de transfert de chaleur (2) au cours de l'agglomération par frittage et pour une température agissant sur la surface de transfert de chaleur (2) au cours de l'agglomération par frittage.

4. Refroidisseur électronique selon l'une quelconque des revendications précédentes, dans lequel une hauteur de la pluralité de conduits de fluide (11) correspond à chaque fois entre une fois et deux fois une largeur de la pluralité de conduits de fluide, où la hauteur s'étend pratiquement de façon orthogonale et la largeur s'étend pratiquement de façon parallèle à un plan d'étendue principale de la surface de transfert de chaleur (2).

5. Refroidisseur électronique selon l'une quelconque des revendications précédentes, dans lequel le dissipateur de chaleur (1) présente une première tôle de conduits (5) et une deuxième tôle de conduits (5), où des conduits de fluide (11) formés par la première tôle de conduits et des conduits de fluide formés par la deuxième tôle de conduits sont disposés en étant décalés les uns par rapport aux autres.

6. Procédé de fabrication d'un refroidisseur électronique selon l'une quelconque des revendications précédentes, procédé qui comprend l'étape suivante :
l'agglomération par frittage (6405) d'au moins un composant électronique sur une surface de transfert de chaleur (2) d'un dissipateur de chaleur (1) qui présente une pluralité de conduits de fluide (11) et la surface de transfert de chaleur servant à l'agglomération par frittage du composant électronique au moins au nombre de un.

7. Utilisation d'un procédé de frittage pour l'agglomération par frittage d'au moins un composant électronique sur une surface de transfert de chaleur (2) d'un dissipateur de chaleur (1) d'un refroidisseur électronique selon l'une quelconque des revendications 1 à 5, dissipateur de chaleur qui présente une pluralité de conduits de fluide (11) et la surface de transfert de chaleur servant à l'agglomération par frittage du composant électronique au moins au nombre de un.
